# EUROPÄISCHE PATENTSCHRIFT

(11) **EP 1 592 729 B1**
(45) Veröffentlichungstag und Bekanntmachung des Hinweises auf die Patenterteilung: **23.04.2008**
(21) Anmeldenummer: 04707888.6
(22) Anmeldetag: 04.02.2004
(51) Int. Cl.: C08G 61/12

(54) **CARBAZOL-ENTHALTENDE KONJUGIERTE POLYMERE UND BLENDS, DEREN DARSTELLUNG UND VERWENDUNG**
CONJUGATED POLYMERS AND BLENDS CONTAINING CARBAZOLE, REPRESENTATION AND USE THEREOF
POLYMERES CONJUGUES CONTENANT DU CARBAZOLE ET MELANGES, PREPARATION ET UTILISATION DESDITS POLYMERES ET MELANGES

(30) Priorität: 06.02.2003 DE 10304819
(43) Veröffentlichungstag der Anmeldung: 09.11.2005
(60) Teilanmeldung: 08003260.0
(73) Patentinhaber: Merck Patent GmbH, 64293 Darmstadt (DE)
(72) Erfinder: PARHAM, Amir, 65929 Frankfurt (DE); FALCOU, Aurelie, 60489 Frankfurt (DE); HEUN, Susanne, 65812 Bad Soden (DE); BECKER, Heinrich, 65817 Eppstein-Niederjosbach (DE); BREUNING, Esther, 65817 Eppstein-Niederjosbach (DE)
(86) Internationale Anmeldenummer: PCT/EP2004/000994
(87) Internationale Veröffentlichungsnummer: WO 2004/070772

(56) Entgegenhaltungen:
- WO-A-03/074628
- ZHU, MOORE: "Synthesis and Characterization of Monodendrons based on 9-Phenylcarbazole" JOURNAL OF ORGANIC CHEMISTRY, Bd. 65, 2000, Seiten 116-123, XP002281495
- SASAKAWA, IKEDA, TAZUKE: "Improved hole drift mobility in excimer-free polymers containing a dimeric carbazole unit" MACROMOLECULES, Bd. 22, 1989, Seiten 4253-4259, XP002281496
- ZOTTI, SCHAVION, ZECCHIN, MORIN, LECLERC: "Electrochemical, conductive and magnetic properties of 2,7-Carbazole-based conjugated polymers" MACROMOLECULES, Bd. 35, 7. Februar 2002 (2002-02-07), Seiten 2122-2128, XP002281497
- WANG, HUA, ZHANG, WANG: "Synthesis and electroluminescent properties of heterocycle-containing poly(p-phenylene vinylene) derivatives" SYNTHETIC METALS, Bd. 99, 1999, Seiten 249-252, XP002281498
- HUANG ET AL.: "Synthesis and electrochemical characterization of a new polymer constituted of carbazole and oxadiazole moieties" SYNTHETIC METALS, Bd. 100, 1999, Seiten 297-301, XP002281499

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 (WO 90/13148) offenbart sind. Seit kurzem ist auch ein erstes Produkt in Form einer kleineren Anzeige (in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln. Vor allem ist es hierbei erforderlich, Polymere für alle Emissionsfarben (rot, grün, blau) zur Verfügung zu stellen, die den Anforderungen des Marktes (Farbsättigung, Effizienz, operative Lebensdauer, Spannung, um die wichtigsten zu nennen) gerecht werden.

Als Polymere für vollfarbige Anzeigeelemente (sog. Full-Colour-Displays) wurden bereits verschiedene Materialklassen vorgeschlagen bzw. entwickelt. So kommen Polyfluoren-Derivate, wie beispielsweise in EP 0842208, WO 99/54385, WO 00/22027, WO 00/22026 und WO 00/46321 offenbart, in Betracht. Des Weiteren sind auch Poly-Spirobifluoren-Derivate, wie in EP 0707020, EP 0894107 und WO 03/020790 offenbart, eine Möglichkeit. Auch Polymere, die eine Kombination der beiden erstgenannten Strukturelemente enthalten, wie in WO 02/077060 offenbart, wurden bereits vorgeschlagen. Im Allgemeinen sind für derartigen Einsatz Polymere, welche Poly-para-Phenylen (PPP) als Strukturelement enthalten, möglich. Neben den oben bereits genannten Klassen kommen hier beispielsweise auch die so genannten Leiter-PPPs ("Ladder-PPPs" = LPPP) (z. B. gemäß WO 92/18552), die Poly-Tetrahydropyrene (z. B. gemäß EP-A-699699), aber auch Ansa-Strukturen enthaltende PPPs (z. B. gemäß EP-A-690086) in Frage.

Wie in einigen der o. g. Anmeldeschriften bereits heraus gearbeitet wurde, ist es für die Erzeugung aller drei Emissionsfarben notwendig, bestimmte Comonomere in die entsprechenden Polymere einzupolymerisieren (vgl. z. B. WO 00/46321, DE 10143353.0 und WO 02/077060). So ist dann i. d. R. - ausgehend von einem blau emittierenden Grundpolymer ("backbone") - die Erzeugung der beiden anderen Primärfarben Rot und Grün möglich.

Des Weiteren wurde berichtet, dass das Einfügen bestimmter Arylamino-Gruppierungen eine Verbesserung der Eigenschaften ergibt:
- WO 99/54385 beschreibt Polyfluorene, deren Effizienz und Einsatzspannung verbessert werden kann, indem Derivate von Triphenylamin, Tetraphenyl-p-diamino-benzol oder Tetraphenyl-4,4'-diamino-biphenyl in die Hauptkette der entsprechenden Polymere mit einpolymerisiert werden.
- DE 19846767 beschreibt Polyfluorene, bei denen ebenfalls die Effizienz und Einsatzspannung verbessert wird, indem substituierte Diarylamino-Einheiten in die Hauptkette eingebaut werden.
- WO 01/49769 beschreibt allgemein Polymere, welche Triarylamino-Gruppen enthalten, bei welchen mindestens eine der Arylgruppen eine Heteroarylgruppe darstellt. Besondere Vorteile dieser Polymere werden nicht beschrieben.
- WO 01/66618 beschreibt Copolymere, welche neben Aryleinheiten auch spezielle Triarylamino- bzw. Tetraaryl-p-diamino-arylen-Einheiten in der Hauptkette enthalten. Die entsprechenden Aminobausteine enthalten dabei jeweils mit Trifluormethylgruppen substituierte Phenyle, die direkt an die Stickstoffatome gebunden sind, allerdings nicht in die Hauptkette eingebaut werden. Als Vorteil wird erwähnt, dass diese Materialien - v. a. im Gegensatz zu den Derivaten, welche in der o. g. WO 99/54385 genannt werden - eine besser einstellbare HOMO-Lage besitzen und dies deshalb in der Anwendung Vorteile erbringt.

Trotz der in den o. g. Anmeldeschriften zitierten Fortschritte gibt es immer noch einen erheblichen Verbesserungsbedarf für entsprechende Materialien. U. a. auf folgenden Feldern sind noch deutliche Verbesserungen nötig:
(1) Die Strom-Spannungskennlinien müssen noch deutlich steiler werden, damit in der Anwendung große Helligkeit bei ausreichend niedrigen Spannungen und somit eine höhere Leistungseffizienz erzielt wird. Dies ist von enormer Bedeutung, da somit einerseits gleiche Helligkeit bei geringerem Energieverbrauch erzielt werden kann, was vor allem bei mobilen Applikationen (Displays für Handys, PDA etc.) sehr wichtig ist. Andererseits erhält man bei gleichem Energieverbrauch höhere Helligkeiten, was beispielsweise für Beleuchtungsanwendungen interessant sein kann.
(2) Viele der beschriebenen BLAU emittierenden Polymere zeigen keine gesättigte tiefblaue Emission, sondern eine hellblaue Emission, deren Farbsättigung nicht für alle Anwendungen ausreichend ist.

Wie aus dieser Beschreibung des Stands der Technik ersichtlich ist, besteht daher weiterhin ein großer Bedarf an Verbesserungen auf dem Gebiet der lichtemittierenden Polymere.

Wir haben überraschend gefunden, dass - bisher unbekannte - Polymere, die bestimmte Carbazol-Einheiten enthalten, deutliche Verbesserungen, gerade auf den beiden o. g. Gebieten, d. h. der Steilheit der Strom-Spannungs-Kennlinien (und damit der Betriebsspannung) und der Farbe, ergeben. Diese sind daher Gegenstand der vorliegenden Anmeldung.

Gegenstand der Erfindung sind daher konjugierte Polymere (POLY1), die 1 -100 mol%, bevorzugt 5-100 mol%, besonders bevorzugt 10-100 mol% Einheiten gemäß Formel (I) enthalten, 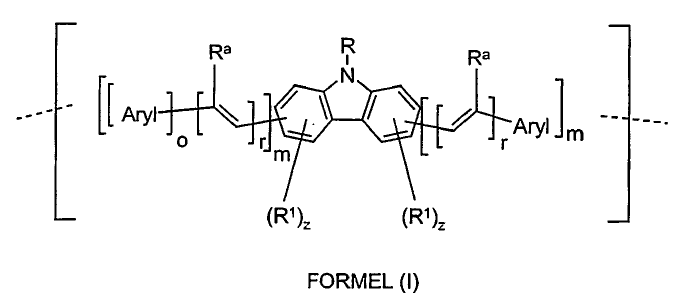 wobei die Symbole und Indizes folgende Bedeutung besitzen:
- R: ist bei jedem Auftreten gleich oder verschieden einem Cycloalkylsystem mit 3 bis 40 C-Atomen, welches substituiert oder unsubstituiert sein kann, einem aromatischen oder heteroaromatischen Ringsystem mit 2 bis 40 C-Atomen, welches substituiert oder unsubstituiert sein kann, oder einem Alkylenaryl-, Alkylencycloalkyl- oder Alkylenheteroaryl-System mit linearer oder verzweigter Alkylenkette mit 1 bis 16 C-Atomen, welches substituiert oder auch unsubstituiert sein kann; die Aryl-, Heteroaryl- und Cycloalkyl-Systeme können dabei auch Teil eines größeren kondensierten aromatischen oder aliphatischen Ringsystems sein; die möglichen Substituenten R¹ können potentiell an jeder freien Position sitzen;
- Aryl: sind bei jedem Auftreten gleich oder verschieden einem aromatischen oder heteroaromatischen Ringsystem mit 2 bis 40 C-Atomen, welches substituiert oder auch unsubstituiert sein kann, oder eine substituierte oder unsubstituierte Stilbenylen- oder Tolanyleneinheit; die möglichen Substituenten R¹ können dabei potentiell an jeder freien Position sitzen;
- R¹: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R²)₂, B(R²)₂, wobei auch zwei oder mehrere Reste R¹ miteinander ein Ringsystem bilden können;
- R^{a}: ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R²)₂, B(R²)₂;
- R²: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
- m: ist bei jedem Auftreten gleich oder verschieden 0, 1 oder 2;
- o: ist bei jedem Auftreten gleich oder verschieden 0, 1 oder 2, unter der Bedingung, dass o nicht 0 sein darf, wenn m = 2 ist;
- r: ist bei jedem Auftreten gleich oder verschieden 0 oder 1,
- z: ist bei jedem Auftreten gleich oder verschieden 0,1,2 oder 3;
die gestrichlte Bindung bedeutet dabei die Verknüpfung im Polymer; sie soll hier keine Methylgruppe darstellen.

Dabei sind verschiedene Verknüpfungen für die Carbazoleinheit in der Polymerkette möglich: Verknüpfung an nur einer der Stellen führt zu einer Endgruppe oder zum Einbau der Struktureinheit gemäß Formel (I) in die Seitenkette; Verknüpfung an zwei Stellen führt zum Einbau des Monomers in die Hauptkette des Polymers; der Einbau der Struktureinheit gemäß Formel (I) in die Hauptkette erfolgt bevorzugt über die 3,6- oder die 2,7-Position des Carbazols oder aber auch über die 2,9- oder 3,9-Position, sofern in den letzten beiden Fällen R ein aromatisches oder heteroaromatisches Ringsystem beschreibt, damit die Konjugation des Polymers gewahrt bleibt. Besonders bevorzugt erfolgt der Einbau über die 3,6- oder die 2,7-Position oder über die 3,9-Position, sofern R ein aromatisches oder heteroaromatisches Ringsystem beschreibt. Ganz besonders bevorzugt erfolgt der Einbau über die 3,6- oder die 2,7-Position. Zur Klarheit wird die Nummerierung des Carbazols in folgender Struktur aufgezeigt: 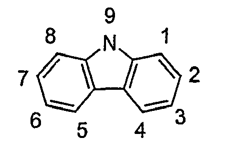 Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich auftretende Defekte, die zu Konjugationsunterbrechungen führen, den Begriff "konjugierte Polymere" nicht entwerten. Des Weiteren wird in diesem Anmeldetext ebenfalls als konjugiert bezeichnet, wenn sich in der Hauptkette beispielsweise Arylamineinheiten wie das Carbazol gemäß Formel (I) oder andere derartige Einheiten und/oder bestimmte Heterocyclen (d. h. Konjugation über N-, O-oder S-Atome) und/oder metallorganische Komplexe (d. h. Konjugation über das Metallatom) befinden. Hingegen würden Einheiten wie beispielsweise einfache (Thio)Etherbrücken, Esterverknüpfungen, Amid- oder Imidverknüpfungen eindeutig als nicht-konjugierte Segmente definiert.

Die erfindungsgemäßen Polymere können neben den Einheiten gemäß Formel (I) noch weitere Strukturelemente enthalten. Dies sind u. a. solche, wie sie in den o. g. Patentanmeldungen bereits offenbart sind. Hier sei vor allem auch auf die relativ umfangreiche Auflistung in der oben schon erwähnten Anmeldeschrift WO 02/077060 verwiesen; diese wird via Zitat als Bestandteil der vorliegenden Erfindung betrachtet. Die weiteren Struktureinheiten können beispielsweise aus den im Folgenden beschriebenen Klassen stammen:
1. Struktureinheiten, die das Polymergrundgerüst bilden können, bzw. BLAU emittierende Einheiten:
   - Hier sind zunächst Poly-Phenylene und davon abgeleitete Strukturen bildende Einheiten zu nennen. Dies sind beispielsweise (jeweils substituierte oder unsubstituierte) ortho-, meta- oder para-Phenylene, 1,4-Naphthylene, 9,1 0-Anthracenylene, 2,7-Phenanthrenylene, 1,6- bzw. 2,7- bzw. 4,9-Pyrenylene oder 2,7-Tetrahydropyrenylene. Auch entsprechende heterocyclische "Poly-Phenylen"-bildende Strukturen, wie beispielsweise 2,5-Thiophenylen, 2,5-Pyrrolylen, 2,5-Furanylen, 2,5-Pyridylen, 2,5-Pyrimidinylen oder 5,8-Chinolinylen kommen in Frage.
   - Des Weiteren sind komplexere Einheiten, wie die o. g. Fluorene, Spiro-9,9'-bifluorene, mehrfach überbrückte Einheiten (z. B. kurze Teilsegmente der o. g. LPPP-Polymere), aber auch "doppelte Fluoren"-Einheiten (Indenofluorene) möglich. Auch diese können substituiert bzw. unsubstituiert sein. Auch entsprechende heterocyclische Strukturen, in denen beispielsweise einzelne Ringkohlenstoffatome durch Heteroatome, wie beispielsweise Schwefel, ersetzt sind, kommen hier in Frage.
2. Struktureinheiten, die die Ladungsinjektions- bzw.
   Ladungstransporteigenschaften erhöhen. Dies kann sich sowohl auf die Elektroneninjektions- oder -transporteigenschaften (wie beispielsweise Oxadiazol-Einheiten) wie auch auf die Lochinjektions- oder -transporteigenschaften (wie beispielsweise Triarylamin-Einheiten) beziehen. Hier sei nochmals auf umfangreiche Auflistung derartiger Struktureinheiten in der oben zitierter Anmeldeschrift WO02/077060 verwiesen; diese wird via Zitat als Bestandteil der vorliegenden Erfindung betrachtet. Ebenso kommen für diesen Zweck Naphthyl-Aryl-Amine in Frage, wie sie in der nicht offengelegten Anmeldeschrift DE 10249723.0 beschrieben werden.
3. Struktureinheiten, die beispielsweise die Farbe der Emission verschieben, damit auch die Bandlücke des Polymers verändern und somit i. d. R. auch die Ladungsinjektions- bzw. -transporteigenschaften verändern:
   - Hier sind beispielsweise weitere heterocyclische Verbindungen, wie die in der o. g. Anmeldung WO 02/077060 unter den Formeln (XX) bis (XXXXV) genannten Strukturen zu nennen.
   - Des weiteren sind hier auch Arylenvinylen- oder Arylenacetylen-Strukturen, wie substituierte oder unsubstituierte Stilbenylene, Tolanylene, Bisstyrylarylene, Bis(arylacetylen)-arylene zu nennen.
   - Schließlich kann auch der Einbau von größeren aromatischen Einheiten, wie zum Beispiel Chrysenen, Naphthacenen, Pentacenen, Perylenen oder Coronenen, den o. g. farbverschiebenden Effekt erzeugen.
4. Struktureinheiten, welche auch bei Raumtemperatur mit hoher Effizienz aus dem Triplettzustand Licht emittieren können:
   - Hier sind zunächst vor allem Verbindungen, welche Schweratome, d. h. Atome aus dem Periodensystem der Elemente mit einer Ordnungszahl von mehr als 36, enthalten, zu verstehen.
   - Besonders geeignet hierfür sind Verbindungen, welche d- und f-Übergangsmetalle enthalten, die die o. g. Bedingung erfüllen. Ganz besonders bevorzugt sind hier entsprechende Struktureinheiten, welche Elemente der Gruppe 8 bis 10 (d. h. Ru, Os, Rh, Ir, Pd, Pt) enthalten.
   - Als Struktureinheiten für die erfindungsgemäßen Polymere kommen hier verschiedene Komplexe in Frage, welche beispielsweise in den Anmeldeschriften WO 02/068435, WO 02/081488, EP 1239526 und der nicht offen gelegten Anmeldeschrift DE 10238903.9 beschrieben sind.

Eine Auswahl bevorzugter weiterer Einheiten der erfindungsgemäßen Polymere sind in der folgenden Übersicht aufgelistet:

| | | |
|---|---|---|
| 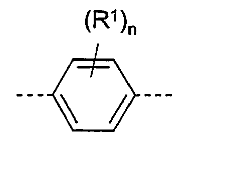 | 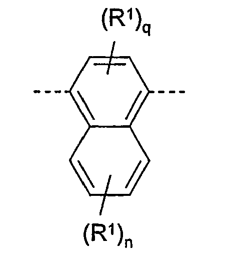 | 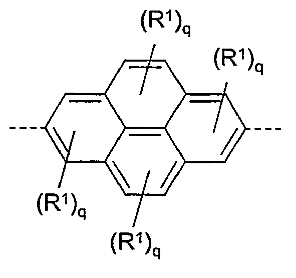 |
| 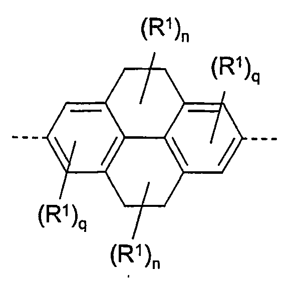 | 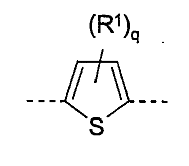 | 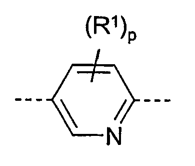 |
| 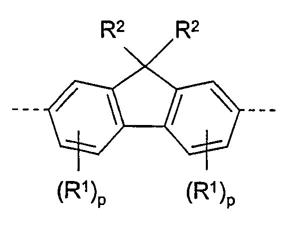 | 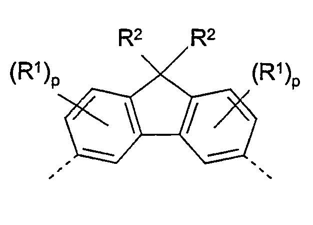 | 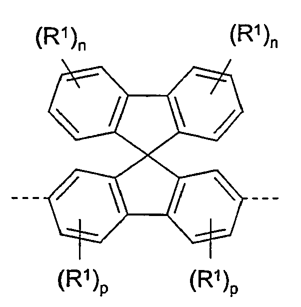 |
| 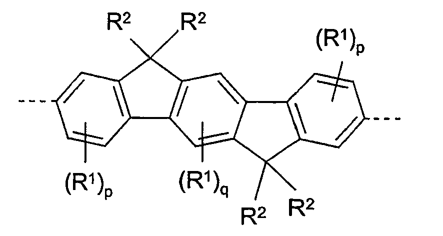 | | 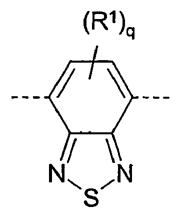 |
| 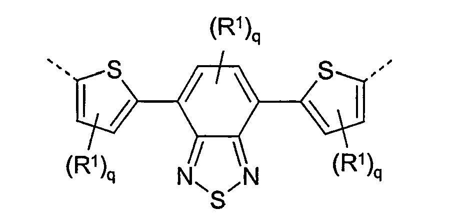 | | 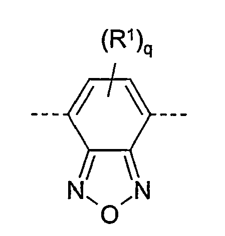 |
| 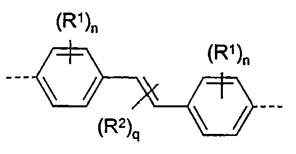 | 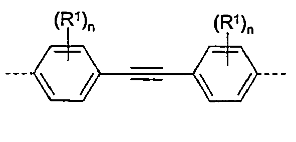 | 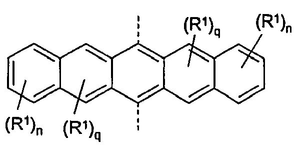 |
| 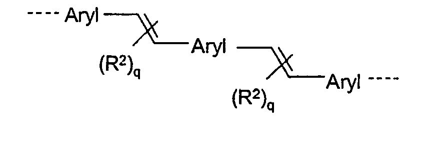 | | 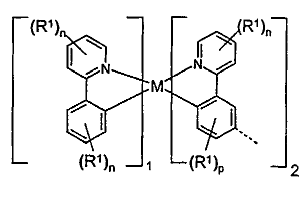 |
| 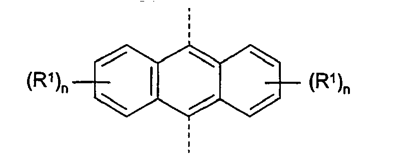 | | 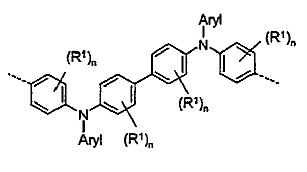 |

Die dabei verwendeten Symbole Aryl, R¹ und R² sind analog den oben bereits Beschriebenen zu verstehen.
- n: ist bei jedem Auftreten gleich oder verschieden 0, 1, 2, 3 oder 4;
- p: ist bei jedem Auftreten gleich oder verschieden 0, 1, 2 oder 3;
- q: ist bei jedem Auftreten gleich oder verschieden 0, 1 oder 2;
- M: ist bei jedem Auftreten gleich oder verschieden Rh oder Ir;
mit den abgebildeten gestrichelten Bindungen ist jeweils die Verknüpfung im Polymer symbolisiert; diese sollen hier keine Methylgruppen darstellen.

Die erfindungsgemäßen Polymere sind entweder Homopolymere, d. h. sie enthalten dann nur eine Struktur der Formel (I), oder es sind Copolymere. Hierbei kann es bevorzugt sein, dass diese entweder mehrere verschiedene Struktureinheiten gemäß Formel (I) enthalten oder neben einer oder mehrerer Struktureinheit(en) gemäß Formel (I), eine oder mehrere der oben beschriebenen bzw. aufgezählten Struktureinheiten enthalten.
Die erfindungsgemäßen Copolymere können sowohl statistische als auch alternierende oder auch blockartige Strukturen aufweisen oder auch mehrere dieser Strukturen abwechselnd besitzen. Durch das Verwenden mehrerer verschiedener Strukturelemente können Eigenschaften wie Löslichkeit, Festphasenmorphologie, Farbe etc. eingestellt werden.

Wie oben beschrieben, enthalten besonders bevorzugte erfindungsgemäße Polymere mindestens 10 mol% Struktureinheiten gemäß Formel (I). Gerade für die Anwendung in den genannten PLEDs als emittierendes Material hat sich ein Anteil in dieser Größenordnung als günstig erwiesen. Für andere Anwendungen, z. B. als Ladungstransportschicht in organischen Feld-Effekt-Transistoren (OFETs), kann sich auch ein deutlich höherer Anteil (bis zu 100 mol%) als günstig erweisen.

Für bevorzugte Strukturen gemäß Formel (I) gilt Folgendes:
- R: ist bei jedem Auftreten gleich oder verschieden einem aromatischen oder heteroaromatischen Ringsystem, ausgewählt aus Thiophen, Benzothiophen, Benzol, Pyridin, Chinoxalin, Fluoren, Spirobifluoren, Naphthalin, Anthracen, Pyren oder Phenanthren, welches an den freien Positionen 0 bis 3 Substituenten R¹ trägt, oder einem Alkylenaryl- oder Alkylen-heteroaryl-Ringsystem, dessen Alkylen-Kette linear oder verzweigt sein kann und aus 1 bis 16 C-Atomen besteht, und dessen Aryl- und Heteroaryl-System aus den oben im einzelnen aufgeführten Systemen besteht, welche an den freien Positionen 0 bis 3 Substituenten R¹ tragen;
- Aryl: ist bei jedem Auftreten gleich oder verschieden einem aromatischen oder heteroaromatischen Ringsystem mit 2 bis 40 C-Atomen, welches substituiert oder auch unsubstituiert sein kann; die Aryl- und Heteroaryl-Systeme können dabei auch Teil eines größeren kondensierten aromatischen Ringsystems sein; die möglichen Substituenten R¹ können, wenn vorhanden, an jeder freien Position sitzen;
- R¹, R², R^{a}, r, z: sind analog den oben gemachten Angaben;
- m: ist bei jedem Auftreten gleich oder verschieden 0 oder 1;
- o: ist bei jedem Auftreten gleich oder verschieden 0, 1 oder 2;
die Verknüpfung der Struktureinheit gemäß Formel (I) in die Hauptkette des Polymers erfolgt über die 3,6- oder 2,7-Position oder über die 2,9- oder 3,9-Position, sofern R eine aromatische oder heteroaromatische Einheit ist.

Für besonders bevorzugte Strukturen gemäß Formel (I) gilt Folgendes:
- R: ist bei jedem Auftreten gleich oder verschieden einem aromatischen oder heteroaromatischen Ringsystem, ausgewählt aus Thiophen, Benzothiophen, Benzol, Pyridin, Naphthalin, Anthracen, Pyren oder Phenanthren, welche unsubstituiert oder mit einem Substituenten R¹ substituiert sind, oder einem 9,9'-substituierten Fluoren oder einem Methylen-aryl- oder Methylen-heteroaryl-Ringsystem, dessen Aryl-bzw. Heteroaryl-System aus den oben im einzelnen aufgeführten Systemen besteht, welche dasselbe Substitutionsmuster tragen können wie die oben genannten Systeme;
- Aryl: ist bei jedem Auftreten gleich oder verschieden einem aromatischen oder heteroaromatischen Ringsystem mit 2 bis 20 C-Atomen, welches substituiert oder auch unsubstituiert sein kann; die Aryl- und Heteroaryl-Systeme können dabei auch Teil eines größeren kondensierten aromatischen Ringsystems sein; die möglichen Substituenten R¹ können dabei potentiell an jeder freien Position sitzen;
- R¹, R², R^{a}, r: sind analog den oben gemachten Angaben;
- m: ist bei jedem Auftreten gleich oder verschieden 0 oder 1;
- o: ist bei jedem Auftreten gleich oder verschieden 0 oder 1;
- z: ist bei jedem Auftreten gleich oder verschieden 0 oder 1;
die Verknüpfung der Struktureinheit gemäß Formel (I) in die Hauptkette des Polymers erfolgt über die 3,6-Position, die 2,7-Position oder die 3,9-Position, sofern R ein Aryl- oder Heteroarylsystem ist.

Besonders bevorzugte Strukturen gemäß Formel (I) sind substituierte oder unsubstituierte Strukturen gemäß den abgebildeten Formeln (II) bis (XXXI), wobei die gestrichelten Bindungen die Verknüpfung im Polymer definieren und potentielle Substituenten wegen der besseren Übersichtlichkeit i. d. R. nicht abgebildet sind:

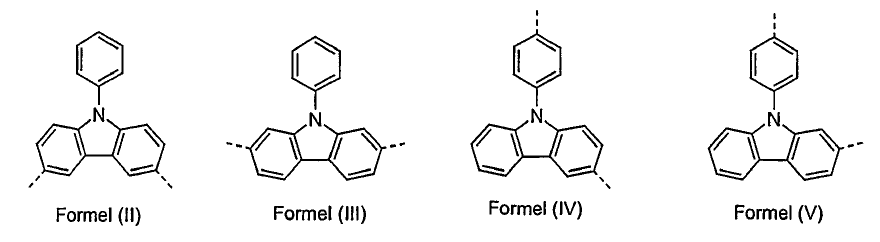

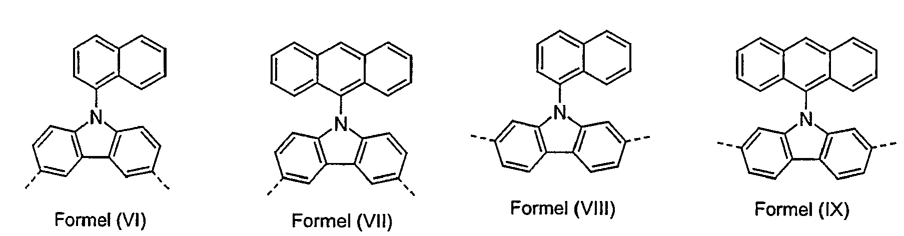

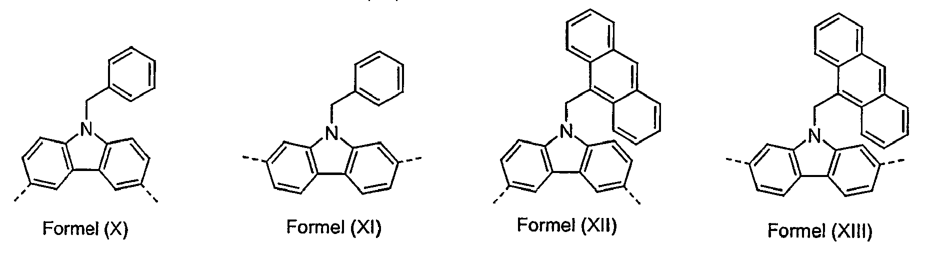

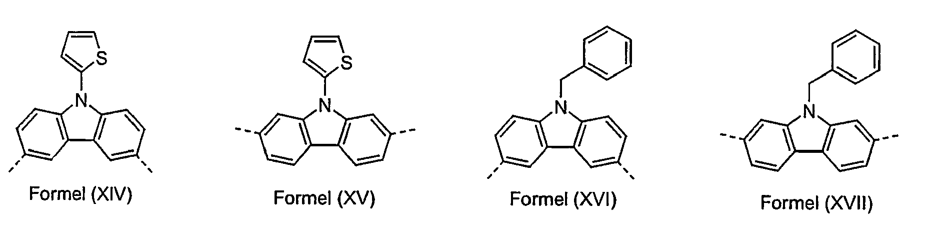

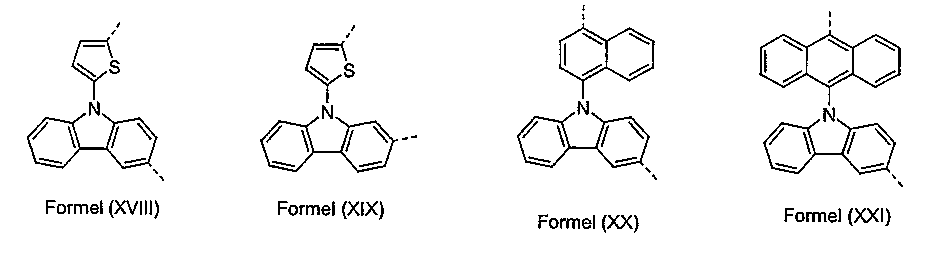

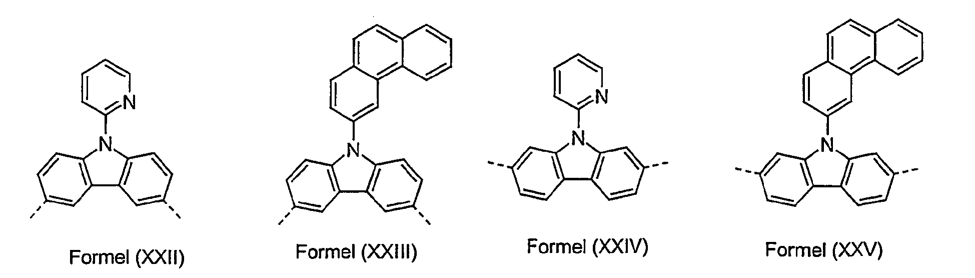

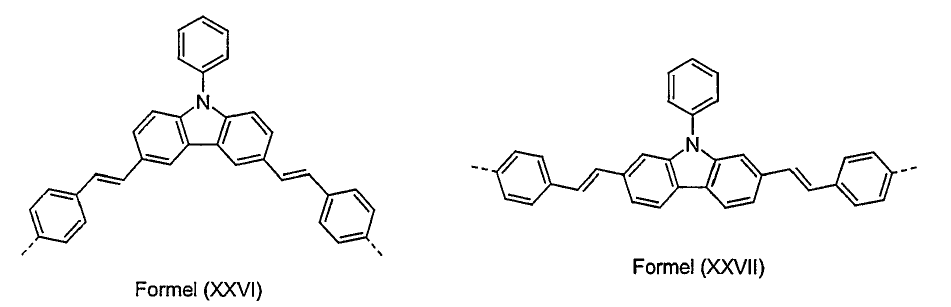

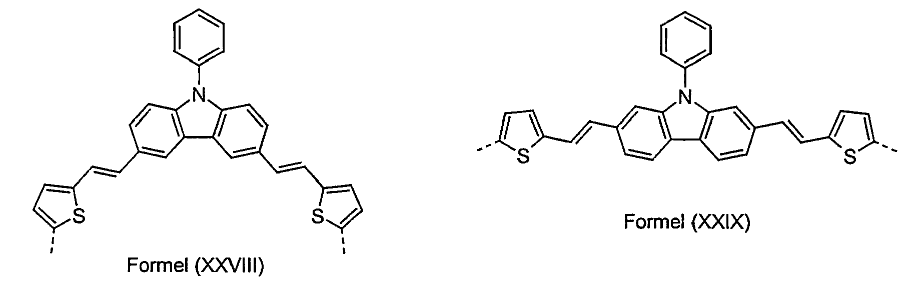

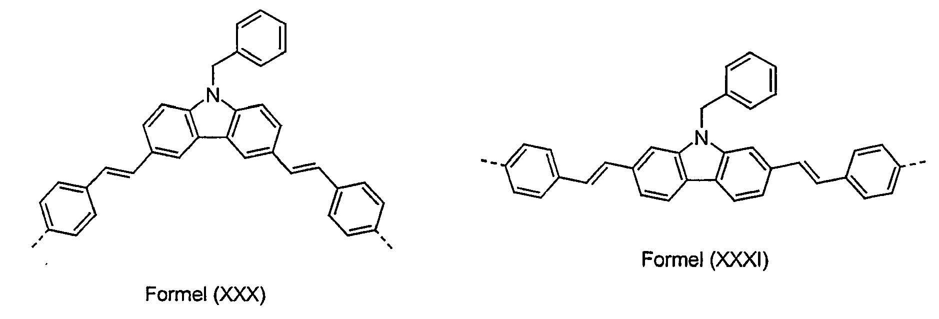

Für ganz besonders bevorzugte Strukturen gemäß Formel (I) gilt Folgendes:
- R: ist bei jedem Auftreten gleich oder verschieden einem aromatischen oder heteroaromatischen Ringsystem, ausgewählt aus Thiophen, Benzothiophen, Benzol, Naphthalin, Anthracen, oder Phenanthren, welche unsubstituiert oder mit einem Substituenten R¹ substituiert sind, oder einer Benzylgruppe, dessen Phenylgruppe dasselbe Substitutionsmuster tragen kann wie die oben genannten Systeme;
- Aryl: ist bei jedem Auftreten gleich oder verschieden einem aromatischen oder heteroaromatischen Ringsystem mit 2 bis 20 C-Atomen, welches substituiert oder auch unsubstituiert sein kann; die Aryl- und Heteroaryl-Systeme können dabei auch Teil eines größeren kondensierten aromatischen Ringsystems sein; die möglichen Substituenten R¹ können dabei potentiell an jeder freien Position sitzen;
- R¹, R², R^{a}, r: sind analog den oben gemachten Angaben;
- m: ist bei jedem Auftreten gleich oder verschieden 0 oder 1;
- o: ist bei jedem Auftreten gleich 1;
dabei erfolgt die Verknüpfung in die Polymerkette über die 3,6- oder die 2,7-Position des Carbazols.

Auch wenn dies aus der Beschreibung hervorgeht, sei hier nochmals explizit darauf verwiesen, dass sowohl die Struktureinheiten gemäß Formel (I), als auch jene gemäß den Formeln (II) bis (XXXI) unsymmetrisch substituiert sein können, d. h. an einer Einheit unterschiedliche Substituenten R¹ vorhanden sein können, bzw. diese auch an unterschiedliche Positionen gebunden sein können.

Die erfindungsgemäßen Polymere weisen in der Regel 10 bis 10000, bevorzugt 50 bis 5000, besonders bevorzugt 50 bis 2000 Wiederholeinheiten auf. Dabei beträgt die Polydispersität PD bevorzugt weniger als 10, besonders bevorzugt weniger als 5.

Die nötige Löslichkeit wird v. a. durch die Substituenten R¹, sowohl an Strukturen gemäß Formel (I), als auch an solchen, die, wie oben geschildert, in entsprechenden Copolymeren noch zusätzlich vorhanden sind, erreicht.

In der Regel ist es deshalb nötig, dass im Durchschnitt pro Wiederholeinheit mindestens 2 nicht-aromatische C-Atome in den Substituenten vorhanden sind. Bevorzugt sind dabei mindestens 4, besonders bevorzugt mindestens 8 C-Atome. Einzelne dieser C-Atome können auch noch durch O oder S ersetzt sein. Dies schließt nicht aus, dass ein gewisser Anteil von Wiederholeinheiten, sowohl solche gemäß Formel (I) als auch anderer Strukturtypen, keine weiteren nicht-aromatischen Substituenten tragen.

Es ist bevorzugt, keine langkettigen Substituenten mit mehr als 12 C-Atomen, bevorzugt keine mit mehr als 8 C-Atomen, besonders bevorzugt keine mit mehr als 6 C-Atomen in einer linearen Kette zu haben, um die Morphologie des Filmes nicht zu verschlechtern.
Nicht-aromatische C-Atome sind, wie in der Beschreibung für R¹, in entsprechenden geradkettigen, verzweigten oder cyclischen Alkyl- oder Alkoxyketten enthalten.

Bevorzugt sind deshalb weiterhin erfindungsgemäße Polymere, bei denen gilt:
- R¹: ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, oder eine Arylgruppe mit 6 bis 14 C-Atomen, welche auch durch ein oder mehrere nicht-aromatische Reste R¹ substituiert ist.

Weiterhin besonders bevorzugt sind deshalb erfindungsgemäße Polymere, bei denen gilt:
- R¹: ist bei jedem Auftreten gleich oder verschieden eine geradkettige oder verzweigte Alkyl- oder Alkoxykette mit 1 bis 8 C-Atomen, oder eine Arylgruppe mit 6 bis 10 C-Atomen, welche auch durch ein oder mehrere nicht-aromatische Reste R¹ substituiert ist.

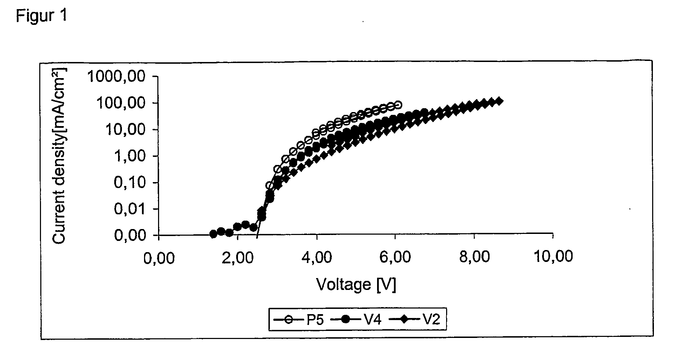

Die erfindungsgemäßen Polymere weisen gegenüber dem o. g. Stand der Technik u. a. folgende überraschenden Vorteile auf:
- Der Strom bei gegebener Spannung ist bei vergleichbaren Polymeren bei der Verwendung in PLEDs deutlich höher (vgl. Angaben in Tabelle 2 und in Abbildung 1), d. h. die Strom-Spannungs-Kennlinie ist steiler, wenn das Polymer Struktureinheiten der Formel (I) enthält. Dies bringt für die Anwendung - wie oben bereits ausgeführt - deutliche Vorteile, da somit das Ziel, effiziente Vollfarbdisplays mit geringerem Energieverbrauch zu erzeugen, ermöglicht wird.
- Überraschend hat die Verwendung von erfindungsgemäßen Polymeren für die Erzeugung blauer Emission noch weitere Vorteile: Die Emissionsfarbe wird noch tiefer (d. h. tiefblau), als diejenige bei analogen Polymeren ohne Struktureinheiten gemäß Formel (I) (vgl. beispielsweise Polymere P1 und P2 mit Polymer V1 und V2).
- Entsprechende Copolymere können so aufgebaut werden, dass diese alle Grundfarben (rot, grün, blau) emittieren können.
- Die Löslichkeit in organischen Lösemitteln ist i. d. R. gut, d. h. in Lösemitteln, wie beispielsweise Toluol, Xylol, Anisol, Methylanisol oder Methylnaphthalin, sind die Polymere in Konzentrationen von 1 bis mindestens 30 g/L (je nach Molekulargewicht) löslich.

Die erfindungsgemäßen Polymere werden in der Regel durch Polymerisation von einem oder mehreren Monomeren, von denen mindestens eines Strukturen der Formel (I) enthält, hergestellt.
Entsprechende Polymerisationsreaktionen gibt es prinzipiell relativ viele verschiedene; es haben sich jedoch die im Folgenden aufgeführten Typen, die alle zu C-C-Verknüpfungen führen, besonders bewährt:
(A) Polymerisation gemäß SUZUKI
(B) Polymerisationen gemäß YAMAMOTO
(C) Polymerisationen gemäß STILLE
(D) Polymerisationen gemäß HARTWIG / BUCHWALD Genauere Ausführungen zu den Polymerisationsmethoden (A) bis (D) können beispielsweise in der nicht offen gelegten Anmeldung DE 10249723.0 gefunden werden. Für Polymere, die Doppelbindungen (Alken-Einheiten) enthalten, kommen auch folgende Methoden zur Polymerisation in Frage:
(E) Polymerisation gemäß WITTIG-HORNER: Hierbei werden als Monomere zum einen Bisaldehyde, zum anderen Bisphosphonate oder entsprechende Monoaldehyd-monophosphonate eingesetzt und unter basischen Bedingungen in Anwesenheit von Lösemitteln zu den entsprechenden Alkenverbindungen umgesetzt. Derartige Reaktionen, welche zu konjugierten Polymeren führen, sind bereits beschrieben: (i) A. P. Davey et al., Synth. Met. 1999, 103, 2478, (ii) S.-H. Jin et al., Eur. Polym. J. 2002, 38, 895. Die entsprechenden Beschreibungen werden hiermit via Zitat als Bestandteil der Anmeldung erachtet.
(F) Polymerisation nach Precursor-Methoden (beispielsweise Sulfoxy Precursor Methode): Ausgehend von Bis(chlormethyl)-Verbindungen, die in der Lage sind, ein Chinodimethan zu bilden, werden zunächst durch einseitige Substitution Alkylthiomethyl-Chlormethyl-Intermediate erhalten. Daraus wird durch Oxidation das Sulfoxid gewonnen. Dieses Vorläufer-Monomer wird unter Bedingungen der Gilch-Polymerisation umgesetzt, wobei das effektive Monomer ein Alkylsulfoxychinodimethan ist. Das somit erhaltene relativ temperaturstabile Vorläufer-Polymer stellt ein Poly(arylen-alkylsulfoxyethylen) dar, das durch reine Temperaturbehandlung unterhalb 200 °C Alkylsulfinsäure eliminiert, unter Bildung des vollständig konjugierten Polymers. Diese Reaktionen sind u. a. in den folgenden Stellen aufgeführt: (i) WO 00/35987 (ii) A. Issaris, D. Vanderzande, Macromolecules 1998, 31, 4426-4431.

Wie die Polymerisationen bevorzugt durchgeführt werden können und wie die Polymere dann von der Reaktionslösung abgetrennt und aufgereinigt werdne, ist beispielsweise in der nicht offen gelegten Anmeldung DE 10249723.0 beschrieben.

Um die entsprechenden erfindungsgemäßen Polymere beispielsweise durch die o. g. Verfahren herstellen zu können, benötigt man - wie beschrieben - die entsprechenden Monomere.
Für Strukturen gemäß Formel (I) können diese beispielsweise wie im Folgenden beschrieben erhalten werden:
- Die Synthese von 3,6-Dibromcarbazol erfolgt durch Bromierung des Carbazols, wie in der Literatur beschrieben: Smith et al., Tetrahedron 1992, 48, 7479-7488.
- Die Synthese von 2,7-Dibromcarbazol erfolgt durch Aufbau des Carbazols, wie in der Literatur beschrieben: Tidwell et al., Eur. J. Med. Chem. 1997, 32, 781-793.
- Eine entsprechende Funktionalisierung, die eine Verwendung als Monomere ermöglicht (also z. B. Einführung von Halogen-Endgruppen), kann entweder an den Vorstufen erfolgen oder als letzter Schritt an dem bereits vollständig aufgebauten monomeren Grundgerüst. Beide Varianten haben, je nach angestrebter Zielstruktur, sowohl Vor- als auch Nachteile.
- Vorab können die Funktionalitäten bereits vorhanden sein, wenn diese bei der Reaktion zum entsprechenden Monomer entweder nicht oder sehr erschwert reagieren. Dies kann z. B. der Fall sein bei einfacher Substitutionsreaktion, oder wenn man unterschiedliche Reaktivitäten (z. B. Iod gegenüber Brom, bzw. Brom gegenüber Chlor) ausnutzen kann. So kann beispielsweise ein Monomer, das Struktureinheiten gemäß Formel (III) ergibt, unter Ausnutzung der Selektivität von Iod gegenüber Brom hergestellt werden, wie in Beispiel 2 beschrieben.
- Andererseits kann es auch vorteilhaft sein (bei z. B. vorliegender Substitution bzw. dirigierenden Resten), zunächst den N-substituierten Carbazolgrundkörper aufzubauen und in einem letzten Schritt das Halogenid einzuführen. So ist es beispielsweise für Strukturen gemäß Formel (II) möglich, in die 3 und 6 Positionen des Carbazols Brom einzuführen (beispielsweise durch milde NBS-Bromierung, vgl. z. B. Creason et al., J. Org. Chem, 1972, 37, 4440), wenn an dem N-Arylsubstituenten in para-Stellung ein Substituent vorhanden ist. Wie oben geschildert, kann dieses Verfahren bei Vorhandensein (i) entsprechender blockierender Substituenten, (ii) entsprechend dirigierender Reste oder (iii) aktivierter bzw. deaktivierter Heterocyclen auch für weitere Strukturen gemäß Formel (I) im Allgemeinen angewendet werden.
- Die N-Alkylierung oder N-Benzylierung von Carbazolen ist in der Literatur bekannt. Ebenso können N-Alkylaryl- und N-Cycloalkyl-Carbazole gewonnen werden. Die Synthese erfolgt durch Reaktion des Carbazols mit einem Alkylierungsmittel unter basischen Bedinungen, wie beispielsweise beschrieben in: M. E. Wright, M.-J. Jin, J. Org. Chem. 1989, 54, 965-968.
- Die N-Arylierung des Carbazols kann gemäß Hartwig-Buchwald erfolgen und wird für Carbazol beispielsweise beschrieben in: M. Watanabe et al:, Tetrahedron Left. 2000, 41, 481-483.
- Ausgehend von den so erzeugten Halogenidderivaten können über Standardverfahren entsprechende Bisboronsäurederivate bzw. Bisstannanderivate (die für die o. g. Polymerisationsverfahren der Typen A und C benötigt werden) hergestellt werden. Diese Verfahren sind dem Fachmann hinlänglich bekannt und bestehen i. d. R. darin, das vorhandene Halogen gegen ein Metall auszutauschen (z. B. Magnesium, Lithium) und dieses dann mit einer Boresterverbindung bzw. einer Trialkylzinnhalogenverbindung umzusetzen. Für die Herstellung von Boronsäurederivaten sind auch katalytische Verfahren zur direkten Umsetzung der Halogenide mit beispielsweise Diboranen unter Anwesenheit von Palladium bekannt. Vergleichbare Reaktionen sind auch für die entsprechenden Zinnverbindungen bekannt. Entsprechende Monohalogenidmonoboronsäure-Derivate bzw. Monohalogenid-monostannan-Verbindungen sind bei geeigneter Stöchiometrie auch erhältlich.
- Ausgehend von den Halogenidderivaten können ebenfalls die entprechenden Bisaldehydderivate, die für das o. g. Polymerisationsverfahren des Typs E benötigt werden, hergestellt werden. Dieses Verfahren ist dem Fachmann hinlänglich bekannt und besteht i. d. R. darin, das vorhandene Halogen gegen ein Metall auszutauschen (z. B. Magnesium, Lithium) und dieses dann mit Ameisensäurederivat (z. B. Dimethylformamid) umzusetzen.
- Die entsprechenden Phosphonatderivate, die für das o. g. Polymerisationsverfahren des Typs E benötigt werden, können ausgehend von den entsprechenden Methylenhalogenidverbindungen erzeugt werden, die dann mit phosphoriger Säure Trialkylester umgesetzt werden. Derartige Verfahren sind dem Fachmann hinlänglich bekannt.

Die Synthese der weiteren Monomere, welche zu Strukturen führen, die nicht denen der Formel (I) entsprechen, die aber oben beschrieben wurden, ist in den bereits oben genannten Anmeldeschriften und Patenten ausführlich beschrieben.
Einen guten Überblick hierzu gibt dabei die Anmeldeschrift WO 02/077060; die dort gemachten entsprechenden Ausführungen werden via Zitat als Bestandteil dieser Anmeldung betrachtet.

Die so erhaltenen Polymere können als Einzelkomponente in unten näher beschriebenen Anwendungen verwendet werden.

Die erfindungsgemäßen Polymere können in PLEDs verwendet werden. Wie PLEDs hergestellt werden können, wird als allgemeines Verfahren ausführlich in DE 10249723.0 beschrieben, das entsprechend für den Einzelfall anzupassen ist.
- Wie oben bereits beschrieben, eignen sich die erfindungsgemäßen Polymere ganz besonders als Elektrolumineszenzmaterialien in derart hergestellten PLEDs oder Displays.

Wie oben beschrieben, eignen sich die erfindungsgemäßen Polymere ganz besonders als Elektrolumineszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, dass die Schicht befähigt ist, bei Anlegen eines elektrischen Feldes Licht abzustrahlen (lichtemittierende Schicht), und/oder dass sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere und/oder Blends enthält. Die aktive Schicht kann beispielsweise eine lichtemittierende Schicht und/oder eine Transportschicht und/oder eine Ladungsinjektionsschicht sein.

PLEDs finden z. B. Anwendung als selbstleuchtende Anzeigeelemente, wie Kontrollampen, alphanumerische Displays, mehr- oder vollfarbige Displays, Hinweisschilder und in optoelektronischen Kopplern.

Im vorliegenden Anmeldetext und auch in den im Weiteren folgenden Beispielen wird auf die Verwendung erfindungsgemäßer Polymere oder Blends in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere oder Blends auch für weitere Verwendungen in anderen elektronischen Devices (Vorrichtungen) zu benutzen, z. B. für organische integrierte Schaltungen (O-ICs), in organischen Feld-Effekt-Transistoren (OFETs), in organischen Dünnfilmtransistoren (OTFTs), für organische Solarzellen (O-SCs), nicht-lineare Optik oder auch organische Laserdioden (O-Laser), um nur einige Anwendungen zu nennen. Gerade für O-ICs und OFETs können entsprechende erfindungsgemäße Polymere, welche einen relativ hohen Anteil an Strukturelementen gemäß Formel (I) besitzen (bevorzugt einen Anteil von mehr als 20 mol%), Verwendung finden.

Die Erfindung wird durch die nachfolgenden Beispiele näher erläutert, ohne sie dadurch einschränken zu wollen.

### Beispiele

### Teil A: Synthese der Monomere und Blendbestandteile:

### A1: Monomere für Einheiten gemäß Formel (I)

3,6-Dibromcarbazol und 2,7-Dibromcarbazol wurden gemäß Smith et al., Tetrahedron 1992, 48, 7479-7488, und Tidwell et al., Eur. J. Med. Chem. 1997, 32, 781-793 synthetisiert. 3,6-Dibrom-N-ethylhexylcarbazol (= EHC) wurde gemäß J. Huang et al., Macromolecules 2002, 35, 6080-6082 synthetisiert. Die strukturelle Integrität aller Produkte wurde mittels ¹H-NMR-Spektroskopie bewiesen, die Reinheit der Produkte wurde mittels HPLC bestimmt.

### Beispiel 1: N-(4-tert-Butylphenyl)-3,6-dibromcarbazol (EM1)

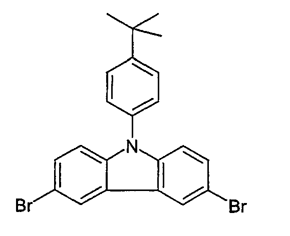

Eine entgaste Lösung von 17 g (80 mmol) 1-Brom-4-teti-butylbenzol in 1500 mL Xylol wurde 1 h mit N₂ gesättigt. Anschließend wurde die Lösung mit 500 g Glaskugeln (6 mm) und 15.37 g (160 mmol) K₃P0₄ versetzt und 15 min. nachgerührt. Nach 5 min Rühren wurde die Reaktionsmischung mit 90 mg (0.4 mmol) Palladium(II)acetat, 400 mg (2 mmol) P(t-Bu)₃ und 10 g (60 mmol) Carbazol versetzt. Die Reaktionsmischung wurde 4 h unter Rückfluss erhitzt. Nach Abkühlen wurde das Lösemittel im Vakuum entfernt und das Produkt aus n-Hexan umkristallisiert. Reinheit gem. HPLC: 99.6 %. Ausbeute: 13 g (68%).
¹H-NMR (CDCl₃, 500 MHz): 1.42 (s, 9 H), 7.26 (t, J₃ = 7.7 Hz, 2 H), 7.40 (m, 4 H), 7.48 (d, J = 8.7 Hz, 2 H), 7.59 (d, J = 8.7 Hz, 2 H), 8.14 (d, J = 8 Hz, 2 H).

12 g (40 mmol) N-(4-*tert-*Butylphenyl)carbazol und 70 g Kieselgel wurden in 700 mL CH₂Cl₂ vorgelegt. Anschließend wurde die Lösung unter Lichtausschluss bei 0 °C portionsweise mit 13 g (80 mmol) NBS versetzt und 2 h bei dieser Temperatur gerührt. Die Mischung wurde mit 100 mL Wasser versetzt und mit CH₂Cl₂ extrahiert. Die organische Phase wurde über MgSO₄ getrocknet und die Lösungsmittel in Vakuum entfernt. Das Produkt wurde mit Hexan heiß ausgerührt und filtriert. Ausbeute: 11 g (66 %) farbloses Pulver, welches eine HPLC-Reinheit von 99.2 % aufwies.
¹H-NMR (CDCl₃, 500 MHz): 1.42 (s, 9 H), 7.25 (d, J = 8.7 Hz, 2 H), 7.39 (d, J = 8.3 Hz, 2 H), 7.48 (dd, J₃ = 8.7 Hz, J₄ = 2 Hz, 2 H), 7.61 (d, J = 8.7 Hz, 2 H), 8.18 (d, J₄ = 8 Hz, 2 H).

### Beispiel 2: N-(4-tert Butylphenyl)-2,7-dibromcarbazol (EM2)

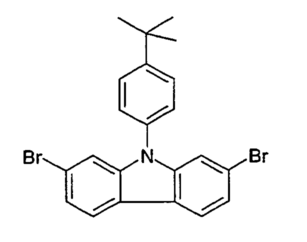

Eine entgaste Lösung von 489.5 mg (0.156 %) Kupfer(I)chlorid und 906 mg (1 %) mmol) 1,10-Phenanthrolin in 100 mL Toluol wurde 1 h mit N₂ gesättigt und auf 130 °C erhitzt. Anschließend wurde die Lösung mit 16.2 g (50 mmol) 2,7-Dibromcarbazol und 13.2 g (50 mmol) 1-lod-4-teri-butylbenzol versetzt und 2 h auf 180 °C erhitzt. Nach Abkühlen wurde die Mischung mit 180 mL Wasser versetzt, die organische Phase abgetrennt und das Lösemittel im Vakuum entfernt. Das Produkt wurde aus n-Hexan umkristallisiert. Ausbeute: 13 g (59 %). Reinheit gem. HPLC: 99.5 %
¹H-NMR (CDCl₃, 500 MHz): 1.43 (s, 9 H), 7.21 (t, J = 7.7 Hz, 2 H), 7.23 (t, J = 7.7 Hz, 2 H), 7.32 (dd, J₃ = 8.7 Hz, J₄ = 1.6 Hz, 2 H), 7.50 (d, J₄ = 1.6 Hz, 2 H), 7.89 (d, J=8.7Hz,2H).

### Beispiel 3: N-(4-tert-Butylphenyl)rnethyl-3,6-dibromcarbazol (EM3)

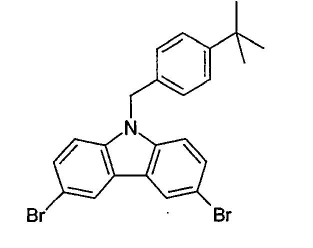

In einem 250 mL Einhalskolben mit Rückflusskühler wurden unter Schutzgas 990 mg (41.2 mmol) NaH in 80 mL trockenem DMF suspendiert. Zu dieser Reaktionsmischung wurden 10 g (30.8 mmol) 3,6-Dibromcarbazol in 80 mL DMF innerhalb 20 min bei RT zugetropft. Anschließend wurde eine Lösung von 4-(tert-butyl)benzylbromid in 50 mL DMF zugetropft und 8 h bei 60 °C erhitzt. Nach Abkühlen auf Raumtemperatur wurden vorsichtig 300 mL Wasser und 200 mL Ethylacetat zugesetzt. Die organische Phase wurde mit 4 x 50 mL H₂O gewaschen, dann über MgSO₄ getrocknet und die Lösungsmittel im Vakuum entfernt. Das reine Produkt erhielt man durch Umkristallisation aus n-Hexan. Ausbeute: 11 g (78 %); HPLC-Reinheit 99.4%.
¹H-NMR (CDCl₃, 500 MHz): 1.22 (s, 9 H), 5.42 (s, 2 H), 6.98 (d, J = 8.7 Hz, 2 H), 7.22 (d, J = 8.7 Hz, 2 H), 7.26 (d, J = 8.4 Hz, 2 H), 7.50 (dd, J₃ = 8.4 Hz, J₄ = 2 Hz, 2 H), 8.14 (d, J₄ = 2 Hz, 2 H).

### Beispiel 4: N-(4-tert-Butylphenyl)methyl-2,7-dibromcarbazol (EM4)

Die Synthese erfolgte in Analogie zu Beispiel 3, ausgehend von 2,7-Dibromcarbazol. Die Ausbeute betrug 94 %.
¹H-NMR (CDCl₃, 500 MHz): 1.21 (s, 9 H), 5.41 (s, 2 H), 6.97 (d, J = 8.7 Hz, 2 H), 7.23 (d, J = 8.7 Hz, 2 H), 7.33 (dd, J₃ = 8.7 Hz, J₄ = 1.6 Hz, 2 H), 7.51 (d, J₄ = 1.6 Hz, 2 H), 7.88 (d, J = 8.7 Hz, 2 H).

### Beispiel 5: N-(4-tert-Butylphenyl)-carbazol-3,6-biscarbaldehyd (EM5)

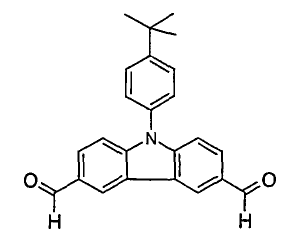

In einem 250 mL Dreihalskolben wurden unter Schutzgas 32 mmol EM1 in 100 mL trockenem THF gelöst. Nach Abkühlung auf -78 °C wurde über ein Septum vorgekühltes BuLi (80 mmol, 15 %ig) unter Rühren in die Lösung injiziert. Unter weiterer Kühlung wurden nach 2 h bei -60 °C 5.2 mL DMF zugetropft. Man ließ auf RT erwärmen und rührte über Nacht weiter. Anschließend wurden vorsichtig 200 mL Eiswasser zugesetzt und mit Chloroform extrahiert. Die organische Phase wurde über MgSO₄ getrocknet und die Lösungsmittel in Vakuum entfernt. Das reine Produkt erhielt man durch Umkristallisation aus n-Hexan. Ausbeute: 8 g (68 %). Reinheit gem. HPLC: 99.1 %
¹H-NMR (CDCl₃, 500 MHz): 1.34 (s, 9 H), 6.38 (d, J = 8.1 Hz, 2 H), 6.82 (d, J = 8.7 Hz, 2 H), 7.04 (d, J = 8.1 Hz, 2 H), 7.18 (d, J = 8.7 Hz, 2 H), 7.31 (d, J = 8.7 Hz, 2 H), 9.2 (s, 2 H).

### Beispiel 6: 3,6-Bis-[2-(4-bromphenyl)ethenyl]-N-(4-tert-butylphenyl)-carbazol (EM6)

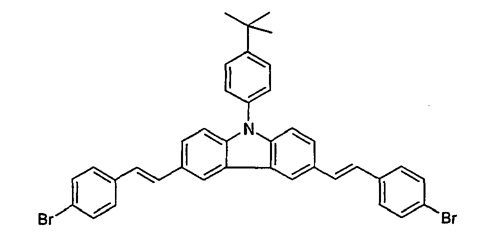

32 mmol 4-Brombenzyldiethylphosphonat wurden unter Schutzgas in 90 mL trockenem DMF gelöst und auf 5 °C gekühlt. Anschließend wurde 60 mmol NaO*^{t}*Bu in kleinen Portionen zugegeben, wobei die Temperatur 5 °C nicht überstieg. Nach 30 min wurden 14.7 mmol **EM5** in 25 mL DMF bei 5 °C zugetropft und noch weitere 30 min bei dieser Temperatur gerührt. Das Reaktionsgemisch wurde abgekühlt, 25 mL 4 M HCl zugetropft und der Niederschlag abgesaugt. Anschließend wurden vorsichtig 100 mL Wasser zugesetzt und mit CH₂Cl₂ extrahiert. Die organische Phase wurde über MgSO₄ getrocknet und die Lösungsmittel in Vakuum entfernt. Das reine Produkt erhielt man durch Umkristallisation aus Ethylacetat/CH₂Cl₂-Mischung (1:1). Ausbeute: 79 g (90 %). Reinheit gemäß HPLC: 99.6 %
¹H-NMR (CDCl₃, 500 MHz): 1.33 (s, 9 H), 6.34 (d, J = 8.1 Hz, 2 H), 7.02 (d, J = 8.1 Hz, 2 H), 7.08 (d, J = 16.4 Hz, 2 H), 7.30 (d, J = 16.4 Hz, 2 H), 7.37 (d, J = 8.3 Hz, 2H),7.41 (d, J = 8.3 Hz, 4 H), 7.48 (d, J = 8.3 Hz, 4 H), 7.64 (dd, J₃ = 8.3 Hz, J₄ = 1.6 Hz, 2 H), 8.23 (d, J₄ = 1.6 Hz, 2 H).

Weitere Monomere gemäß Formel (I) bzw. Formeln (II) bis (XXXI) wurden in Analogie zu den oben genannten Beispielen synthetisiert.

### A2: Monomere für weitere Einheiten

Die Synthese der weiteren Monomere M1 bis M23 ist bereits in WO 02/077060 und der darin zitierten Literatur ausführlich beschrieben. Die Monomere sind zur besseren Übersicht im Folgenden nochmal dargestellt:

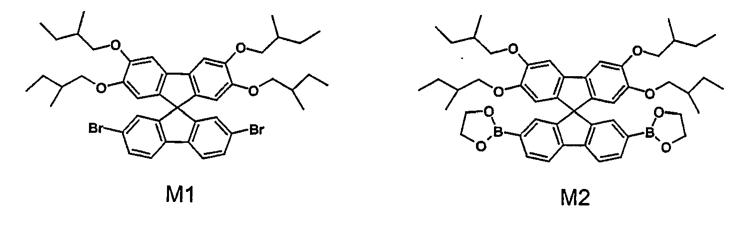

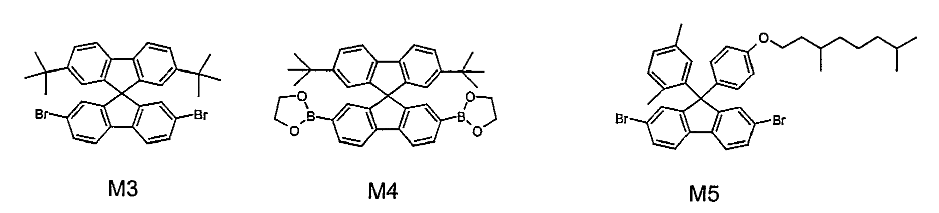

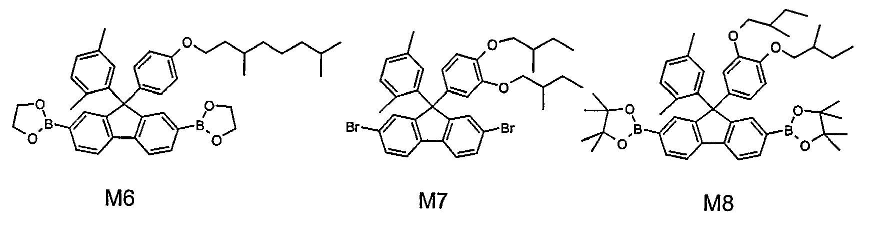

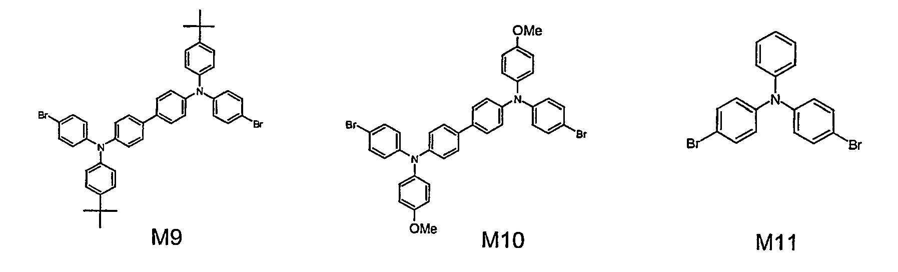

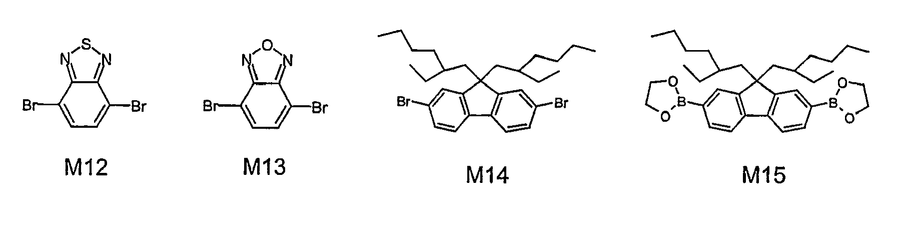

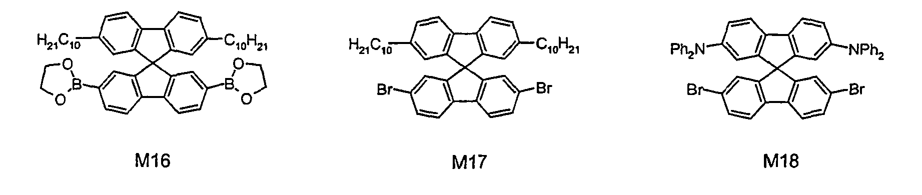

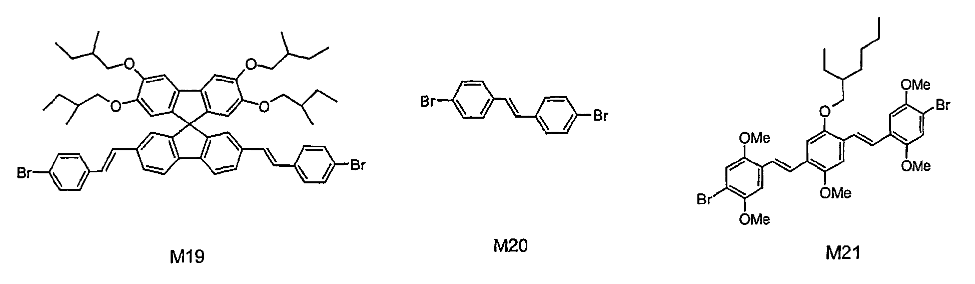

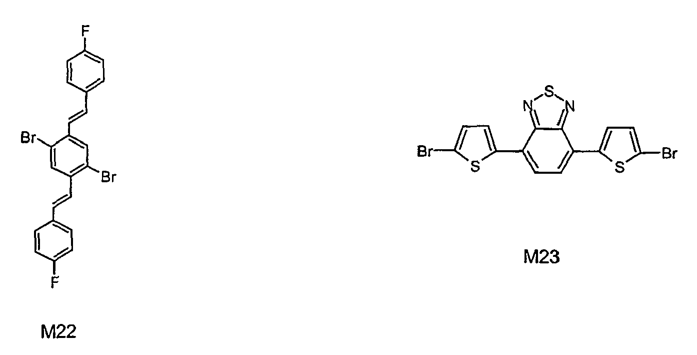

### A3: Niedermolekulare Verbindungen

Bei den hier in erfindungsgemäßen Blends beispielhaft verwendeten niedermolekularen Verbindungen handelt es sich beispielsweise um lösliche Derivate von Tris(phenylpyridyl)-Iridium(III). Die Synthese dieser Verbindungen ist bereits beschrieben in der Anmeldeschrift WO 02/081488 und in der nicht offen gelegten Patentanmeldung DE 10238903.9.

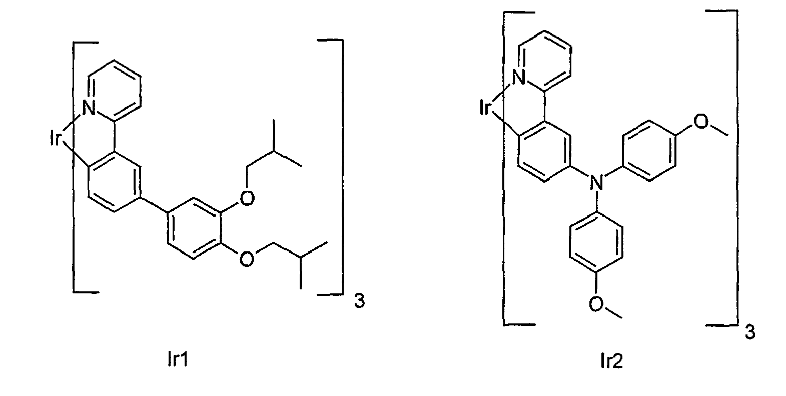

### Teil B: Herstellung der Polymere

### Synthese von Polymer P1:

3.2026 g (4 mmol) Monomer M2, 1.6237 g (2.4 mmol) Monomer M7, 0.6069 g (0.8 mmol) Monomer M9, 0.3770 g (0.8 mmol) EM1 und 3.91 g (2.125 Äquivalente) Kaliumphosphat Hydrat wurden gelöst in 37.5 mL Dioxan, 12.5 mL Toluol und 6.8 mL H₂O (alle Lösungsmittel sauerstofffrei). Die Reaktionslösung wurde 30 Minuten bei 40 °C mit Argon entgast. Dann wurden 0.45 mg (0.025 %) Pd(OAc)₂ und 3.65 mg (0.15 %) P(o-tolyl)₃ als Katalysator zugegeben, und die Lösung wurde 1.5 h unter Rückfluss unter einer Argon-Atmosphäre erhitzt. Die hochviskose Polymerlösung wurde mit 20 mL Toluol verdünnt. Dann wurde das Endcapping durchgeführt, indem 100 mg Benzolboronsäure zugegeben wurden, 45 Minuten unter Rückfluss erhitzt, dann Zugabe von 0.2 ml Brombenzol und weitere 45 Minuten unter Rückfluss erhitzt. Die Polymerlösung wurde bei 60 °C mit 100 ml 0.01 %-iger wässriger NaCN-Lösung 3 h gerührt. Dann wurden die Phasen getrennt und die organische Phase mit 4 x 100 mL H₂O gewaschen. Das Polymer wurde durch Zugabe des doppelten Volumens an Methanol ausgefällt und filtriert. Weitere Reinigung erfolgte durch Lösen in 200 mL Toluol bei 60 °C unter Argon, Filtration durch eine Glasfritte und erneute Ausfällung durch Zugabe des doppelten Volumens Methanol. Das Polymer wurde filtriert und unter Vakuum getrocknet. Es wurden 4.85 g (96 % d. Th.) Polymer isoliert, Mw = 578000, Mn = 156000, Polydispersität = 3.7.

### Synthese von Polymer P2:

Das Polymer wurde in Analogie zu Polymer P1 mit 3.2026 g (4 mmol) Monomer M2, 1.0825 g (1.6 mmol) Monomer M7, 0.6069 g (0.8 mmol) Monomer M9, 0.8185 g (0.8 mmol) Monomer M19, 0.3658 g (0.8 mmol) EM4 und 3.91 g (2.125 Äquivalente) Kaliumphosphat Hydrat in 25 mL Dioxan, 25 mL Toluol und 6.8 mL H₂O synthetisiert. Es wurden 4.57 g (92 % d. Th.) Polymer isoliert, Mw = 791000, Mn = 239000, Polydispersität = 3.3.

Weitere Polymere wurden analog der Beschreibung für P1 dargestellt. Die chemischen Eigenschaften sind in Tabelle 1 zusammengefasst. Es wurden auch einige Vergleichspolymere (die keine Einheiten gemäß Formel (I) enthalten) dargestellt. Auch diese sind in der Tabelle mit aufgeführt.

Alle Polymere wurden auch für einen Einsatz in PLEDs untersucht. Wie PLEDs dargestellt werden können, ist zum einen oben schon ausgeführt und wird in Teil C beschrieben.

Auch einige Device-Eigenschaften (Farbe, Effizienz und Betriebsspannung) sind in der Tabelle 1 mit aufgeführt.

In Tabelle 2 und Abbildung 1 sind die Strom-Spannungs-Charakteristika einiger Polymere dokumentiert. Hier kann man sehr gut erkennen, dass die Kurven bei den erfindungsgemäßen Polymeren deutlich steiler ansteigen und der Strom bei gegebener Spannung bei den erfindungsgemäßen Polymeren deutlich höher ist als bei den Vergleichspolymeren gemäß Stand der Technik.

In Tabelle 3 sind einige Device-Eigenschaften (Farbe, Effizienz und Betriebsspannung) von referenzen Blends aufgeführt und verglichen mit Blends, die dem Stand der Technik entsprechen.

**Tabelle 1.**

| | Anteil der Monomere in der Polymerisation [%] | | | | GPC** | | Elektrolumlneszenz*** | | | | Visco.***** |
|---|---|---|---|---|---|---|---|---|---|---|---|
| Polymer (TyP)* | Monom.1 ; | Monom.2 ; | Monom.3 ; (+ evt. Mono. 4) | EM | M_{w} (.1000 g/mol) | M_{N} (1000 g/mol) | λₘₐₓ [nm] | Max. Eff [Cd/A] | Spannung bei 100 Cd/m² M | CIE-Koordinaten*** (x / y) | Geltemp. [°C] |
| P1 (S) | 50% M2 | 30%M7 | 10% M9 | 10% EM1 | 578 | 156 | 449 | 3.10 | 4.7 | 0.1510.12 | < 0 °C |
| P2 (S) | 50% M2 | 20% M7 | 10%M9, | 10% EM4 | 791 | 239 | 455/ | 2.12 | 5.8 | 0.18/0.25 | < 0 °C |
| | | | 10% M 19 10% | | | | 482 | | | | |
| P3 (S) | 50% M2 | 40% M1 | | 10% EM2 | 624 | 132 | 433/ | 2.25 | 4.4 | 0.16 / 0.10 | < 0°C |
| | | | | | | | 449 | | | | |
| P4 (S) | 50% M2 | | | 50% EM3 | 298 | 61 | 427 | 1.24 | 7.9 | 0.16 / 0.06 | |
| P5 (S) | 50%M2 | 30%M7 | 10%M19 | 10% EM3 | 824 | 204 | 454/ | 5,06 | 3.6 | 0.17 / 0.25 | < 0 °C |
| | | | | | | | 481 | | | | |
| P6 (S)^{a} | 50% M2 | | | 50% EHC^{b} | 298 | 61 | | | | | |
| P7 (S)^{a} | 50% M2 | | | 50% EM1 | 308 | 79 | | | | | |
| P8 (S)^{a} | 50%M2 | 40% M1 | | 10% EHC^{b} | 764 | 200 | | | | | |
| P9 (S)^{a} | 50% M2 | 10% M1 | 10% M9 | 30% EHC^{b} | 350 | 114 | | | | | |
| V1 (S) | 50% M2 | 40% M7 | 10% M9 | | 1190 | 199 | 464 | 3.42 | 4.9 | 0.16 / 0.17 | < 0 °C |
| V2 (S) | 50%M2 | 30% M7 | 10%M9, | | 464 | 126 | 459/ | 5.31 | 4.2 | 0.18 / 0.29 | < 0 °C |
| | | | 10% M19 | | | | 484 | | | | |
| V3 (S) | 50%M2 | 50% M1 | | | 207 | 63 | 433/ | 1.38 | 4.8 | 0.16/0.11 | < 0 °C |
| V4 (S) | 50% M2 | 40% M7 | 10% M19 ; | | 520 | 170 | 461/ | 3.99 | 4.1 | 0.16 / 0.25 | < 0 °C |

| | | | | | | | | | | | |
|---|---|---|---|---|---|---|---|---|---|---|---|
| *S = Durch Suzuki-Polymerisation hergestellt (vgl. Bsp. P1), Y = durch Yamamoto-Polymerisation hergestellt **GPC Messungen THF; 1 ml/min, Plgel 10µm Mixed-B 2 x 300 x 7.5 mm², 35 °C, RI Detektion wurde gegen Polystyrol geeicht *** Zur Herstellung der Polymer LEDs, siehe Teil C **** CIE-Koordinaten: Chromatizitäts-Koordinaten der Commission Internationale de l'Eclairage *****Lösungen des Polymers (10mg/ml) in Toluol wurden auf 60 °C erwärmt, mit 1 °C/Minute abgekühlt und die Viscosität wurde in einem Brookfield LVDV-III Rheometer (CP-41) gemessen. Bei der so ermittelten Geltemperatur tritt ein starker Anstieg in der Viskosität auf. ^{a}Polymer P6 bis Polymer P9 wurden nur in Blends mit Triplettemittern (s. Tabelle 3) untersucht. ^{b}EHC = 3,6-Dibrom-N-ethylhexylcarbazol | | | | | | | | | | | |

**Tabelle 2.**

| **Polymer** | **Stromdichte (mA/cm²) bei einer Spannung von** | | | | |
|---|---|---|---|---|---|
| | 2 V | 3 V | 4 V | 5 V | 6 V |
| **P5** | 0 | 0.3 | 4.6 | 18.3 | 51.7 |
| **V2** | 0 | 0.2 | 2.6 | 12.3 | 38.0 |
| **V4** | 0 | 0.1 | 1.7 | 6.5 | 16.4 |

Vergleich des Stroms bei unterschiedlichen Spannungen (am Beispiel eines erfindungsgemäßen Polymeren und zwei Polymeren ähnlicher Zusammensetzung, die jedoch keine Struktureinheiten gemäß Formel (I) enthalten).

Figur 1 zeigt einen Vergleich der Strom-Spannungs-Kennlinien für das erfindungsgemäße Polymer P5 (enthaltend 10 % Carbazol) mit dem Vergleichspolymer V2 (enthaltend 10 % des Lochleiters M9, aber kein Carbazol) und dem Vergleichspolymer V4 (enthaltend keinen anderen Lochleiter und auch kein Carbazol).

**Tabelle 3.**

| | Blend-Zusammensetzung | | | Elektrolumineszenz* | | | |
|---|---|---|---|---|---|---|---|
| Blend | Polymer | Iridium-Komplex | Anteil Ir-Komplex [%] | λₘₐₓ [nm] | Max. Eff. [cd/A] | Spannung bei 100 Cd/m² [V] | CIE1931-Koordinaten** (x/y) |
| B1 | P5 | Ir1 | 8 | 534 | 9.29 | 5.90 | 0.40/0.58 |
| B2 | P5 | Ir2 | 8 | 604 | 6.22 | 10.62 | 0.59/0.41 |
| B3 | P6 | Ir1 | 8 | 532 | 9.23 | 5.88 | 0.38/0.60 |
| B4 | P7 | Ir1 | 8 | 532 | 12.82 | 6.92 | 0.38/0.60 |
| B5 | P7 | Ir1 | 20 | 532 | 14.49 | 5.87 | 0.38/0.60 |
| B6 | P6 | Ir2 | 8 | 604 | 6.27 | 10.60 | 0.50/0.61 |
| B7 | P8 | Ir2 | 8 | 611 | 4.42 | 6.41 | 0.62/0.38 |
| B8 | P8 | Ir2 | 20 | 614 | 7.53 | 4.35 | 0.62/0.38 |
| B9 | P9 | Ir2 | 8 | 606 | 6.62 | 6.91 | 0.60/0.40 |
| | | | | | | | |
| VB1 | V3 | Ir1 | 8 | 529 | 0.65 | 6.33 | 0.36/0.55 |
| VB2 | V3 | Ir2 | 8 | 605 | 0.40 | 6.70 | 0.60/0.39 |
| VB3 | PVK*** | Ir1 | 8 | 520 | 7.13 | 13.71 | 0.37/0.60 |
| VB4 | PVK*** | Ir2 | 8 | 600 | 3.64 | 13.41 | 0.58 / 0.42 |

| | | | | | | | |
|---|---|---|---|---|---|---|---|
| * Zur Herstellung der Polymer LEDs, siehe Teil C ** CIE-Koordinaten: Chromatizitäts-Koordinaten der Commission Internationale de l'Eclairage von 1931 *** PVK = Poly(vinylcarbazol) | | | | | | | |

### Teil C: Herstellung und Charakterisierung von LEDs:

Alle Polymere und Blends wurden für einen Einsatz in PLEDs untersucht. Diese PLEDs waren jeweils Zweischichtsysteme, d. h. Substrat//ITO//PEDOT//Polymer//Kathode. PEDOT ist ein Polythiophen-Derivat (Baytron P von H. C. Stark, Goslar). Als Kathode wurde in allen Fällen Ba/Ag (beide von Aldrich) verwendet. Wie PLEDs dargestellt werden können, ist in DE 10249723.0 und der darin zitierten Literatur ausführlich beschrieben.

## Patentansprüche

1. Konjugierte Polymere (POLY1), **dadurch gekennzeichnet, dass** sie 1-100 mol% Einheiten gemäß Formel (I) enthalten, 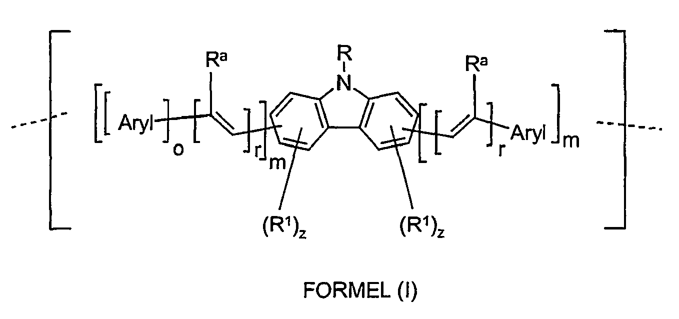 wobei die Symbole und Indizes folgende Bedeutung besitzen:
R ist bei jedem Auftreten gleich oder verschieden einem Cycloalkylsystem mit 3 bis 40 C-Atomen, welches substituiert oder unsubstituiert sein kann, einem aromatischen oder heteroaromatischen Ringsystem mit 2 bis 40 C-Atomen, welches substituiert oder unsubstituiert sein kann, oder einem Alkylenaryl-, Alkylencycloalkyl- oder Alkylenheteroaryl-System mit linearer oder verzweigter Alkylenkette mit 1 bis 16 C-Atomen, welches substituiert oder auch unsubstituiert sein kann; die Aryl-, Heteroaryl- und Cycloalkyl-Systeme können dabei auch Teil eines größeren kondensierten aromatischen oder aliphatischen Ringsystems sein; die möglichen Substituenten R¹ können potentiell an jeder freien Position sitzen;
Aryl sind bei jedem Auftreten gleich oder verschieden einem aromatischen oder heteroaromatischen Ringsystem mit 2 bis 40 C-Atomen, welches substituiert oder auch unsubstituiert sein kann, oder eine substituierte oder unsubstituierte Stilbenylen- oder Tolanyleneinheit; die möglichen Substituenten R¹ können dabei potentiell an jeder freien Position sitzen;
R¹ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nichtaromatische Reste R¹ substituiert sein können, oder Cl, F, CN, N(R²)₂, B(R²)₂, wobei auch zwei oder mehrere Reste R¹ miteinander ein Ringsystem bilden können;
R^{a} ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch N-R², O, S, -CO-O-, O-CO-O ersetzt sein können, wobei auch ein oder mehrere H-Atome durch Fluor ersetzt sein können, eine Aryl- oder Aryloxygruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können, oder Cl, F, CN, N(R²)₂, B(R²)₂,;
R² ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, -CO-O-, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können, welche auch durch ein oder mehrere nicht-aromatische Reste R¹ substituiert sein können;
m ist bei jedem Auftreten gleich oder verschieden 0, 1 oder 2;
o ist bei jedem Auftreten gleich oder verschieden 0, 1 oder 2, unter der Bedingung, dass o nicht 0 sein darf, wenn m = 2 ist;
r ist bei jedem Auftreten gleich oder verschieden 0 oder 1,
z ist bei jedem Auftreten gleich oder verschieden 0, 1, 2 oder 3;
die gestrichelte Bindung stellt dabei die Verknüpfung im Polymer dar; sie soll hier keine Methylgruppe darstellen.

2. Polymere gemäß Anspruch 1, **dadurch gekennzeichnet, dass** die Einheiten gemäß Formel (I) in die Seitenkette des Polymers gebunden sind und über die Position 2 oder die Position 3 des Carbazols mit der Hauptkette des Polymers verknüpft sind.

3. Polymere gemäß Anspruch 1, **dadurch gekennzeichnet, dass** die Struktureinheiten gemäß Formel (I) über die Positionen 3 und 6 oder über die Positionen 2 und 7 des Carbazols in die Polymerhauptkette eingebaut sind.

4. Polymere gemäß Anspruch 1 **dadurch gekennzeichnet, dass** die Struktureinheiten gemäß Formel (I) über die Positionen 3 und 9 des Carbazols oder über die Positionen 2 und 9 des Carbazols in die Polymerkette eingebaut sind, sofern R ein Aryl- oder Heteroarylsystem ist, so dass die Konjugation der Kette erhalten bleibt.

5. Polymere gemäß einem oder mehreren der Ansprüche 1 bis 4, **dadurch gekennzeichnet, dass** weitere Strukturelemente anwesend sind.

6. Polymere gemäß Anspruch 5, **dadurch gekennzeichnet, dass** die weiteren Strukturelemente aus den Gruppen ortho-, meta- oder para-Phenylene, 1,4-Naphthylene, 9,10-Anthracenylene, 2,7-Phenanthrenylene, 1,6- bzw. 2,7- bzw. 4,9-Pyrenylene oder 2,7-Tetrahydropyrenylene, Oxadiazolylene, 2,5-Thiophenylene, 2,5-Pyrrolylene, 2,5-Furanylene, 2,5-Pyridylene, 2,5-Pyrimidinylene, 5,8-Chinolinylene, Fluorene, Spiro-9,9'-bifluorene, Indenofluorene oder Heteroindenofluorene ausgewählt sind.

7. Polymere gemäß Anspruch 5 , **dadurch gekennzeichnet, dass** weitere Strukturelemente anwesend sind, die Ladungstransport und/oder -injektion verbessern.

8. Polymere gemäß Anspruch 7, **dadurch gekennzeichnet, dass** die weiteren Strukturelemente aus den Gruppen der Triarylamine bzw. der Oxadiazolylene ausgewählt sind.

9. Polymere gemäß Anspruch 5, **dadurch gekennzeichnet, dass** die weiteren Strukturelemente aus Gruppen, die die Farbe der Emission verschieben, damit auch die Bandlücke des Polymers verändern und somit i. d. R. auch die Ladungsinjektions- bzw. -transporteigenschaften verändern, ausgewählt sind.

10. Polymere gemäß Anspruch 9, **dadurch gekennzeichnet, dass** die weiteren Strukturelemente aus den Gruppen Arylenvinylen- oder Arylenacetylen-Strukturen und/oder größeren aromatischen Einheiten ausgewählt sind.

11. Polymere gemäß Anspruch 5, **dadurch gekennzeichnet, dass** sie Metallkomplexe enthalten, welche einen Transfer von Singulett-Excitonen zu Triplett-Excitonen ermöglichen und die aus dem Triplettzustand Licht emittieren.

12. Polymere gemäß Anspruch 11, **dadurch gekennzeichnet, dass** die Metallkomplexe d- und f-Übergangsmetalle, enthalten.

13. Polymere gemäß Anspruch 12, **dadurch gekennzeichnet, dass** die Metallkomplexe Metalle der Gruppe 8 bis 10 enthalten.

14. Polymere gemäß einem oder mehreren der Ansprüche 1 bis 13, **dadurch gekennzeichnet, dass** für die Symbole und Indizes Folgendes gilt:
R ist bei jedem Auftreten gleich oder verschieden einem aromatischen oder heteroaromatischen Ringsystem, ausgewählt aus Thiophen, Benzothiophen, Benzol, Naphthalin, Anthracen, oder Phenanthren, welche unsubstituiert oder mit einem Substituenten R¹ substituiert sind, oder einem Benzyl-Ringsystem, dessen Phenylgruppe dasselbe Substitutionsmuster trägt wie die oben genannten Systeme;
Aryl ist bei jedem Auftreten gleich oder verschieden einem aromatischen oder heteroaromatischen Ringsystem, ausgewählt aus Thiophen, Benzol, Pyridin, Fluoren, Spirobifluoren, Anthracen, Phenanthren, Pyren, Chinolin oder Naphthalin, welches an den freien Positionen 0 bis 2 Substituenten R¹ trägt;
R¹, R², R^{a}, o, r, z sind wie in Anspruch 1 beschrieben;
m ist bei jedem Auftreten gleich oder verschieden 0 oder 1.

15. Polymere gemäß einem oder mehreren der Ansprüche 1 bis 14, **dadurch gekennzeichnet, dass** die Strukturelemente gemäß Formel (I) aus den Formeln (II) bis (XXXI) ausgewählt werden, die substituiert oder unsubstituiert sein können.

16. Polymere gemäß einem oder mehreren der Ansprüche 1 bis 15, **dadurch gekennzeichnet, dass** im Durchschnitt pro Wiederholeinheit mindestens 2 nicht-aromatische C-Atome in den Substituenten vorhanden sind.

17. Polymere gemäß einem oder mehreren der Ansprüche 1 bis 16, **dadurch gekennzeichnet, dass** keine Substituenten mit mehr als 12 C-Atomen in einer linearen Kette enthalten sind.

18. Polymere gemäß einem oder mehreren der Ansprüche 1 bis 17, **dadurch gekennzeichnet, dass** diese durch SUZUKI-Kupplung, YAMAMOTO-Kupplung, STILLE-Kupplung, HARTWIG-BUCHWALD-Kupplung, WITTIG-HORNER-Reaktion oder einem Precursor-Verfahren hergestellt werden.

19. Verwendung eines Polymers gemäß einem oder mehreren der Ansprüche 1 bis 18 in organischen integrierten Schaltungen (O-ICs), in organischen Feld-Effekt-Transistoren (OFETs), in organischen Dünnfilmtransistoren (OTFTs), in organischen Solarzellen (O-SCs), in organischen Leuchtdioden (OLED), in organischen Laserdioden (O-Laser) oder in der nicht-linearen Optik.

20. Elektronisches Bauteil, welches eine oder mehrere aktiven Schichten umfasst, wobei mindestens eine dieser aktiven Schichten ein oder mehrere Polymere gemäß einem oder mehreren der Ansprüche 1 bis 18 enthält.

21. Elektronisches Bauteil gemäß Anspruch 20, **dadurch gekennzeichnet, dass** es sich um eine organische Leuchtdiode handelt.

## Claims

1. Conjugated polymers (POLY1), **characterised in that** they comprise 1-100 mol% of units of the formula (I) 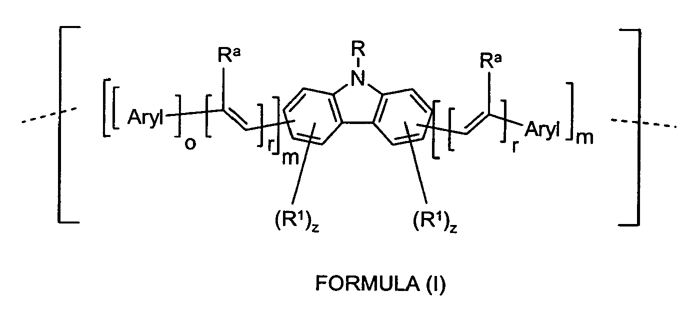 where the symbols and indices have the following meaning:
R is on each occurrence, identically or differently, a cycloalkyl system having 3 to 40 C atoms, which may be substituted or unsubstituted, an aromatic or heteroaromatic ring system having 2 to 40 C atoms, which may be substituted or unsubstituted, or an alkylenearyl, alkylenecycloalkyl or alkyleneheteroaryl system having a linear or branched alkylene chain having 1 to 16 C atoms, which may be substituted or also unsubstituted; the aryl, heteroaryl and cycloalkyl systems here may also be part of a larger condensed aromatic or aliphatic ring system; the possible substituents R¹ can potentially be in any free position;
aryl is on each occurrence, identically or differently, an aromatic or heteroaromatic ring system having 2 to 40 C atoms, which may be substituted or also unsubstituted, or a substituted or unsubstituted stilbenylene or tolanylene unit; the possible substituents R¹ here can potentially be in any free position;
R¹ is on each occurrence, identically or differently, a straight-chain, branched or cyclic alkyl or alkoxy chain having 1 to 22 C atoms, in which, in addition, one or more non-adjacent C atoms may be replaced by N-R², O, S, -CO-O-, O-CO-O and in which one or more H atoms may be replaced by fluorine, an aryl or aryloxy group having 5 to 40 C atoms, in which, in addition, one or more C atoms may be replaced by O, S or N and which may be substituted by one or more non-aromatic radicals R¹, or Cl, F, CN, N(R²)₂, B(R²)₂, where, in addition, two or more radicals R¹ may form a ring system with one another;
R^{a} is on each occurrence, identically or differently, a straight-chain, branched or cyclic alkyl or alkoxy chain having 1 to 22 C atoms, in which, in addition, one or more non-adjacent C atoms may be replaced by N-R², O, S, -CO-O-, O-CO-O and in which one or more H atoms may be replaced by fluorine, an aryl or aryloxy group having 5 to 40 C atoms, in which, in addition, one or more C atoms may be replaced by O, S or N and which may be substituted by one or more non-aromatic radicals R¹, or Cl, F, CN, N(R²)₂, B(R²)₂;
R² is on each occurrence, identically or differently, H, a straight-chain, branched or cyclic alkyl chain having 1 to 22 C atoms, in which, in addition, one or more non-adjacent C atoms may be replaced by O, S, -CO-O-, O-CO-O and in which one or more H atoms may be replaced by fluorine, an aryl group having 5 to 40 C atoms, in which, in addition, one or more C atoms may be replaced by O, S or N and which may be substituted by one or more non-aromatic radicals R¹;
m is on each occurrence, identically or differently, 0, 1 or 2;
o is on each occurrence, identically or differently, 0, 1 or 2, with the condition that o cannot be 0 if m = 2;
r is on each occurrence, identically or differently, 0 or 1;
z is on each occurrence, identically or differently, 0, 1, 2 or 3;
the dashed bond here represents the link in the polymer; it is not intended to represent a methyl group here.

2. Polymers according to Claim 1, **characterised in that** the units of the formula (I) are bonded into the side chain of the polymer and are linked to the main chain of the polymer via position 2 or position 3 of the carbazole.

3. Polymers according to Claim 1, **characterised in that** the structural units of the formula (I) are incorporated into the main polymer chain via positions 3 and 6 or via positions 2 and 7 of the carbazole.

4. Polymers according to Claim 1, **characterised in that** the structural units of the formula (I) are incorporated into the polymer chain via positions 3 and 9 of the carbazole or via positions 2 and 9 of the carbazole if R is an aryl or heteroaryl system, so that the conjugation of the chain is retained.

5. Polymers according to one or more of Claims 1 to 4, **characterised in that** further structural elements are present.

6. Polymers according to Claim 5, **characterised in that** the further structural elements are selected from the groups ortho-, meta- or para-phenylenes, 1,4-naphthylenes, 9,10-anthracenylenes, 2,7-phenanthrenylenes, 1,6- or 2,7- or 4,9-pyrenylenes or 2,7-tetrahydropyrenylenes, oxadiazolylenes, 2,5-thiophenylenes, 2,5-pyrrolylenes, 2,5-furanylenes, 2,5-pyridylenes, 2,5-pyrimidinylenes, 5,8-quinolinylenes, fluorenes, spiro-9,9'-bifluorenes, indenofluorenes or heteroindenofluorenes.

7. Polymers according to Claim 5 , **characterised in that** further structural elements which improve charge transport and/or injection are present.

8. Polymers according to Claim 7, **characterised in that** the further structural elements are selected from the groups of the triarylamines or the oxadiazolylenes.

9. Polymers according to Claim 5, **characterised in that** the further structural elements are selected from groups which shift the colour of the emission, thus also change the band gap of the polymer and thus generally also modify the charge-injection or -transport properties.

10. Polymers according to Claim 9, **characterised in that** the further structural elements are selected from the groups arylenevinylene or aryleneacetylene structures and/or larger aromatic units.

11. Polymers according to Claim 5, **characterised in that** they contain metal complexes which facilitate transfer of singlet excitons to triplet excitons and which emit light from the triplet state.

12. Polymers according to Claim 11, **characterised in that** the metal complexes contain d- and f-transition metals.

13. Polymers according to Claim 12, **characterised in that** the metal complexes contain metals from groups 8 to 10.

14. Polymers according to one or more of Claims 1 to 13, **characterised in that** the following applies to the symbols and indices:
R is on each occurrence, identically or differently, an aromatic or hetero-aromatic ring system selected from thiophene, benzothiophene, benzene, naphthalene, anthracene or phenanthrene, which is unsubstituted or substituted by a substituent R¹, or a benzyl ring system whose phenyl group carries the same substitution pattern as the systems mentioned above;
aryl is on each occurrence, identically or differently, an aromatic or hetero-aromatic ring system selected from thiophene, benzene, pyridine, fluorene, spirobifluorene, anthracene, phenanthrene, pyrene, quinoline or naphthalene which carries 0 to 2 substituents R¹ in the free positions;
R¹, R², R^{a}, o, r, z are as described in Claim 1;
m is on each occurrence, identically or differently, 0 or 1.

15. Polymers according to one or more of Claims 1 to 14, **characterised in that** the structural elements of the formula (I) are selected from formulae (II) to (XXXI), which may be substituted or unsubstituted.

16. Polymers according to one or more of Claims 1 to 15, **characterised in that** on average at least two non-aromatic C atoms are present in the substituents per recurring unit.

17. Polymers according to one or more of Claims 1 to 16, **characterised in that** no substituents having more than 12 C atoms are present in a linear chain.

18. Polymers according to one or more of Claims 1 to 17, **characterised in that** they are prepared by SUZUKI coupling, YAMAMOTO coupling, STILLE coupling, HARTWIG-BUCHWALD coupling, WITTIG-HORNER reaction or a precursor process.

19. Use of a polymer according to one or more of Claims 1 to 18 in organic integrated circuits (O-ICs), in organic field-effect transistors (OFETs), in organic thin-film transistors (OTFTs), in organic solar cells (O-SCs), in organic light-emitting diodes (OLEDs), in organic laser diodes (O-lasers) or in non-linear optics.

20. Electronic component which comprises one or more active layers, where at least one of these active layers comprises one or more polymers according to one or more of Claims 1 to 18.

21. Electronic component according to Claim 20, **characterised in that** it is an organic light-emitting diode.

## Revendications

1. Polymères conjugués (POLY1), **caractérisés en ce qu'**ils comprennent 1-100 mol% d'unités de la formule (I) 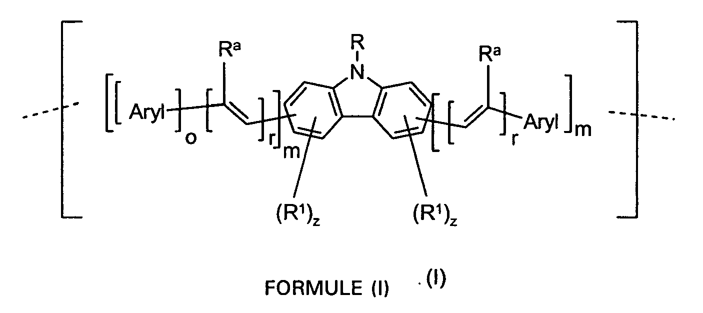 dans laquelle les symboles et indices présentent les significations qui suivent :
R est, lors de chaque occurrence, de manière identique ou différente, un système cycloalkyle comportant de 3 à 40 atomes de C, lesquels peuvent être substitués ou non substitués, un système de cycle aromatique ou hétéroaromatique comportant de 2 à 40 atomes de C, lesquels peuvent être substitués ou non substitués, ou un système alkylènearyle, alkylènecycloalkyle ou alkylènehétéroaryle comportant une chaîne alkylène linéaire ou ramifiée comportant de 1 à 16 atomes de C, lesquels peuvent être substitués ou également non substitués ; les systèmes aryle, hétéroaryle et cycloalkyle peuvent ici également être une partie d'un système de cycle aromatique ou aliphatique condensé plus grand ; les substituants possibles R¹ peuvent ici potentiellement être en n'importe quelle position libre ;
aryl est, lors de chaque occurrence, de manière identique ou différente, un système de cycle aromatique et hétéroaromatique comportant de 2 à 40 atomes de C, lesquels peuvent être substitués ou également non substitués, ou une unité stilbénylène ou tolanylène substituée ou non substituée ; les substituants possibles R¹ peuvent ici potentiellement être en n'importe quelle position libre ;
R¹ est, lors de chaque occurrence, de manière identique ou différente, une chaîne alkyle ou alcoxy en chaîne droite, ramifiée ou cyclique comportant de 1 à 22 atomes de C où, en plus, un ou plusieurs atomes de C non adjacents peut/peuvent être remplacé(s) par N-R², O, S, -CO-O-, O-CO-O et où un ou plusieurs atomes de H peut/peuvent être remplacé(s) par fluor, un groupe aryle ou aryloxy comportant de 5 à 40 atomes de C où, en plus, un ou plusieurs atomes de C peut/peuvent être remplacé(s) par O, S ou N et lesquels peuvent être substitués par un ou plusieurs radicaux non aromatiques R¹, ou Cl, F, CN, N(R²)₂, B(R²)₂, où, en plus, deux radicaux R¹ ou plus peuvent former un système de cycle l'un avec l'autre ou les uns avec les autres ;
R^{a} est, lors de chaque occurrence, de manière identique ou différente, une chaîne alkyle ou alcoxy en chaîne droite, ramifiée ou cyclique comportant de 1 à 22 atomes de C où, en plus, un ou plusieurs atomes de C non adjacents peut/peuvent être remplacé(s) par N-R², O, S, -CO-O-, O-CO-O et où un ou plusieurs atomes de H peut/peuvent être remplacé(s) par fluor, un groupe aryle ou aryloxy comportant de 5 à 40 atomes de C où, en plus, un ou plusieurs atomes de C peut/peuvent être remplacé(s) par O, S ou N et lesquels peuvent être substitués par un ou plusieurs radicaux non aromatiques R¹, ou Cl, F, CN, N(R²)₂, B(R²)₂ ;
R² est, lors de chaque occurrence, de manière identique ou différente, H, une chaîne alkyle en chaîne droite, ramifiée ou cyclique comportant de 1 à 22 atomes de C où, en plus, un ou plusieurs atomes de C non adjacents peut/peuvent être remplacé(s) par O, S, -CO-O-, O-CO-O et où un ou plusieurs atomes de H peut/peuvent être remplacé(s) par fluor, un groupe aryle comportant de 5 à 40 atomes de C où, en plus, un ou plusieurs atomes de C peut/peuvent être remplacé(s) par O, S ou N et lesquels peuvent être substitués par un ou plusieurs radicaux non aromatiques R¹ ;
m est, lors de chaque occurrence, de manière identique ou différente, 0, 1 ou 2 ;
o est, lors de chaque occurrence, de manière identique ou différente, 0, 1 ou 2, moyennant pour condition que o ne peut pas être 0 si m = 2 ;
r est, lors de chaque occurrence, de manière identique ou différente, 0 ou 1 ;
z est, lors de chaque occurrence, de manière identique ou différente, 0, 1, 2 ou 3 ;
le lien en pointillés représente ici la liaison dans le polymère ; il n'est pas destiné à représenter un groupe méthyle ici.

2. Polymères selon la revendication 1, **caractérisés en ce que** les unités de la formule (I) sont reliées dans la chaîne latérale du polymère et sont liées à la chaîne principale du polymère via la position 2 ou la position 3 du carbazole.

3. Polymères selon la revendication 1, **caractérisés en ce que** les unités structurelles de la formule (I) sont incorporées dans la chaîne polymérique principale via les positions 3 et 6 ou via les positions 2 et 7 du carbazole.

4. Polymères selon la revendication 1, **caractérisés en ce que** les unités structurelles de la formule (I) sont incorporées dans la chaîne polymérique via les positions 3 et 9 du carbazole ou via les positions 2 et 9 du carbazole si R est un système aryle ou hétéroaryle, de telle sorte que la conjugaison de la chaîne est conservée.

5. Polymères selon une ou plusieurs des revendications 1 à 4, **caractérisés en ce que** des éléments structurels supplémentaires sont présents.

6. Polymères selon la revendication 5, **caractérisés en ce que** les éléments structurels supplémentaires sont choisis parmi les groupes ortho-, méta- ou paraphénylènes, 1,4-naphtylènes, 9,10-anthracénylènes, 2,7-phénanthrénylènes, 1,6- ou 2,7- ou 4,9-pyrénylènes ou 2,7-tétrahydropyrénylènes, oxadiazolylènes, 2,5-thiophénylènes, 2,5-pyrrolylènes, 2,5-furanylènes, 2,5-pyridylènes, 2,5-pyrimidinylènes, 5,8-quinolinylènes, fluorènes, spiro-9,9'-bifluorènes, indénofluorènes ou hétéroindénofluorènes.

7. Polymères selon la revendication 5, **caractérisés en ce que** des éléments structurels supplémentaires qui améliorent le transport de charges et/ou l'injection de charges sont présents.

8. Polymères selon la revendication 7, **caractérisés en ce que** les éléments structurels supplémentaires sont choisis parmi les groupes des triarylamines ou des oxadiazolilènes.

9. Polymères selon la revendication 5, **caractérisés en ce que** les éléments structurels supplémentaires sont choisis parmi des groupes qui décalent la couleur de l'émission, qui modifient par conséquent également la bande interdite du polymère et qui, par conséquent, modifient également de façon générale les propriétés d'injection de charges ou de transport de charges.

10. Polymères selon la revendication 9, **caractérisés en ce que** les éléments structurels supplémentaires sont choisis parmi les groupes de structures arylènevinylène ou arylèneacétylène et/ou des unités aromatiques plus grandes.

11. Polymères selon la revendication 5, **caractérisés en ce qu'**ils contiennent des complexes métalliques qui facilitent un transfert excitons singlets à excitons triplets et qui émettent de la lumière à partir de l'état triplet.

12. Polymères selon la revendication 11, **caractérisés en ce que** les complexes métalliques contiennent des métaux de transition d et f.

13. Polymères selon la revendication 12, **caractérisés en ce que** les complexes métalliques contiennent des métaux issus des groupes 8 à 10.

14. Polymères selon une ou plusieurs des revendications 1 à 13, **caractérisés en ce que** ce qui suit s'applique aux symboles et indices :
R est, lors de chaque occurrence, de manière identique ou différente, un système de cycle aromatique ou hétéroaromatique choisi parmi thiophène, benzothiophène, benzène, naphtalène, anthracène ou phénanthrène, lequel est non substitué ou substitué par un substituant R¹, ou un système de cycle benzyle dont un groupe phényle est porteur du même motif de substitution que les systèmes mentionnés ci avant ;
aryl est, lors de chaque occurrence, de manière identique ou différente, un système de cycle aromatique ou hétéroaromatique choisi parmi thiophène, benzène, pyridine, fluorène, spirobifluorène, anthracène, phénanthrène, pyrène, quinoline ou naphtalène qui est porteur de 0 à 2 substituants R¹ au niveau des positions libres ;
R¹, R², R^{a}, o, r, z sont comme décrit selon la revendication 1 ;
m est, lors de chaque occurrence, de manière identique ou différente, 0 ou 1.

15. Polymères selon une ou plusieurs des revendications 1 à 14, **caractérisés en ce que** les éléments structurels de la formule (I) sont choisis à partir des formules (II) à (x;XXI), lesquels peuvent être substitués ou non substitués.

16. Polymères selon une ou plusieurs des revendications 1 à 15, **caractérisés en ce que**, en moyenne, au moins deux atomes de C non aromatiques sont présents dans les substituants par unité récurrente.

17. Polymères selon une ou plusieurs des revendications 1 à 16, **caractérisés en ce qu'**aucun substituant comportant plus de 12 atomes de C n'est présent dans une chaîne linéaire.

18. Polymères selon une ou plusieurs des revendications 1 à 17, **caractérisés en ce qu'**ils sont préparés au moyen d'un couplage de SUZUKI, d'un couplage de YAMAMOTO, d'un couplage de STILLE, d'un couplage de HARTWIG-BUCHWALD, d'une réaction de WITTIG-HORNER ou d'un processus par précurseur.

19. Utilisation d'un polymère selon une ou plusieurs des revendications 1 à 18 dans des circuits intégrés organiques (O-IC), dans des transistors à effet de champ organiques (OFET), dans des transistors à film mince organiques (OTFT), dans des cellules solaires organiques (O-SC), dans des diodes émettrices de lumière organiques (OLED), dans des diodes laser organiques (O-lasers) ou dans des optiques non linéaires.

20. Composant électronique qui comprend une ou plusieurs couches actives où au moins l'une de ces couches actives comprend un ou plusieurs polymères selon une ou plusieurs des revendications 1 à 18.

21. Composant électronique selon la revendication 20, **caractérisé en ce qu'**il s'agit d'une diode émettrice de lumière organique.
